(19) Europäisches Patentamt / European Patent Office / Office européen des brevets

(11) **EP 4 517 592 A1**

(12) **EUROPEAN PATENT APPLICATION**
published in accordance with Art. 153(4) EPC

(43) Date of publication:
05.03.2025 Bulletin 2025/10

(21) Application number: 23819284.3

(22) Date of filing: 11.06.2023

(51) International Patent Classification (IPC):
*G06N 3/08* (2023.01)        *G06F 5/01* (2006.01)

(52) Cooperative Patent Classification (CPC):
G06F 5/01; G06F 15/16; G06N 3/08; G06N 3/098;
H04L 69/04

(86) International application number:
PCT/CN2023/099570

(87) International publication number:
WO 2023/237121 (14.12.2023 Gazette 2023/50)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 10.06.2022  CN 202210658140
20.10.2022  CN 202211289095

(71) Applicant: Huawei Technologies Co., Ltd.
Shenzhen, Guangdong 518129 (CN)

(72) Inventors:
• HU, Tianchi
  Shenzhen, Guangdong 518129 (CN)
• JUNSONG, Wang
  Shenzhen, Guangdong 518129 (CN)
• SHEN, Shengyu
  Shenzhen, Guangdong 518129 (CN)

(74) Representative: Pfenning, Meinig & Partner mbB
Patent- und Rechtsanwälte
Theresienhöhe 11a
80339 München (DE)

(54) **DATA PROCESSING METHOD AND APPARATUS AND RELATED DEVICE**

(57)    This application provides a data processing method and apparatus, and a related device. The method includes: A computing device determines a first reference value based on a plurality of pieces of to-be-compressed first data; then calculates a difference between each piece of first data and the first reference value; determines a code corresponding to each difference; and obtains compressed data of corresponding first data based on each code. Lengths of some or all codes in codes corresponding to all first data are less than lengths of original first data. The reference value is data with a larger quantity of occurrence times in the plurality of pieces of to-be-compressed data. When the difference between the reference value and each of the plurality of pieces of to-be-compressed data is calculated, a quantity of 0s in a plurality of obtained differences is the largest. After the difference is encoded, the data corresponding to the difference can be compressed to a smaller quantity of bits. Because a code occupies fewer bits than the data, data compression can be implemented, an amount of data to be exchanged between different computing devices can be reduced, and data transmission efficiency can be improved.

```
┌─────────────────────────────────────────────────────────┐
│ Determine one first reference value based on a plurality │──── S201
│ of pieces of to-be-compressed first data                 │
└─────────────────────────────────────────────────────────┘
                          │
                          ▼
┌─────────────────────────────────────────────────────────┐
│ Determine a difference between each piece of first data  │──── S202
│ and the first reference value                            │
└─────────────────────────────────────────────────────────┘
                          │
                          ▼
┌─────────────────────────────────────────────────────────┐
│ Determine a code corresponding to each difference, and   │──── S203
│ obtain compressed data of corresponding first data based │
│ on each code                                             │
└─────────────────────────────────────────────────────────┘
```

FIG. 2

EP 4 517 592 A1

**Description**

This application claims priorities to Chinese Patent Application No. 202210658140.2, filed with the China National Intellectual Property Administration on June 10, 2022 and entitled "ARTIFICIAL INTELLIGENCE MODEL DATA COMPRESSION METHOD", and to Chinese Patent Application No. 202211289095.4, filed on October 20, 2022 and entitled "DATA PROCESSING METHOD AND APPARATUS AND RELATED DEVICE", both of which are incorporated herein by reference in their entireties.

**TECHNICAL FIELD**

This application relates to the field of computer technologies, and in particular, to a data processing method and apparatus and a related device.

**BACKGROUND**

With development of information technologies, a demand for application data and multimedia communication services increases greatly. A large amount of data needs to be transmitted or exchanged between different devices over a network. For example, in application like high-performance computing (high performance computing, HPC), artificial intelligence (Artificial Intelligence, AI) model training, and multimedia data transmission, to improve computing efficiency, improve user experience, and the like, efficiency of data exchange between different devices needs to be improved, and a latency in a data transmission process needs to be reduced. Reducing an amount of data to be transmitted between different devices is an effective way to improve data exchange efficiency and reduce a latency. Therefore, how to reduce an amount of data to be exchanged between different devices is a technical problem to be resolved.

**SUMMARY**

This application provides a data processing method and apparatus and a related device, to compress to-be-transmitted data, so as to reduce an amount of to-be-transmitted data, improve data exchange efficiency, and reduce a data transmission latency.

According to a first aspect, this application provides a data processing method. The method includes: A computing device determines a first reference value based on a plurality of pieces of to-be-compressed first data; then calculates a difference between each piece of first data and the first reference value; determines a code corresponding to each difference; and obtains compressed data of corresponding first data based on each code. Lengths of some or all codes in codes corresponding to all first data are less than lengths of original first data.

The reference value is data with a larger quantity of occurrence times in the plurality of pieces of to-be-compressed data. After the difference between the reference value and each of the plurality of pieces of to-be-compressed data is calculated, and the code corresponding to each piece of data is determined based on the difference, lengths of codes corresponding to some or all data are less than lengths of the original first data, and a quantity of 0s in differences between the reference value and the plurality of pieces of data is the largest. After a difference that is 0 in the differences is encoded, data corresponding to the difference 0 can be compressed to a smaller quantity of bits. Because a code occupies fewer bits than the data, data compression can be implemented, an amount of data to be exchanged between different computing devices can be reduced, and data transmission efficiency can be improved.

In a possible implementation, the plurality of pieces of first data are respective exponential values of a plurality of floating point numbers.

In application like AI model training, a data type of data such as a weight in a model and an activation value or a gradient generated in a model training process is usually a floating point (float point, FP) type, for example, a double-precision floating point type (FP64), a single-precision floating point type (FP32), and a half-precision floating point type (FP16). Compressing an exponential value in a floating point number can reduce a data amount of the floating point number in a transmission process, improve data transmission efficiency, and reduce a data latency. For AI model training, an amount of data to be exchanged in an AI model training process can be reduced, a data transmission latency can be reduced, and model training efficiency can be improved.

In a possible implementation, the determining a code corresponding to each difference includes: determining the code corresponding to each difference based on each difference and a code table, where codes corresponding to a plurality of preset differences are recorded in the code table. The code table is stored in the computing device. After a difference between a piece of data and the reference value is calculated, a corresponding code can be determined based on the code table.

In a possible implementation, in the code table, a code corresponding to a difference whose absolute value is greater than a threshold is a fixed value, and the obtaining compressed data of corresponding first data based on each code includes: when an absolute value of a first difference is greater than the threshold, using the fixed value and first data corresponding to the first difference as compressed data of the first data corresponding to the first difference.

Optionally, if the plurality of pieces of first data are the respective exponential values of the plurality of floating point numbers, for any first exponential value in the exponential values, a code corresponding to a first difference between the first exponential value and the reference value is determined based on the code table. When an absolute value of the first difference is less than or equal to a first threshold, the code corresponding to the first difference is used as a code corresponding to the first exponential value. When an absolute value of the first difference is greater than a first threshold, the code corresponding to the first difference and the first exponential value are used as a code corresponding to the first exponential value. The reference value is an exponential value with a larger quantity of occurrence times. When a difference between the reference value and each of a plurality of to-be-compressed exponential values is calculated, a quantity of 0s in a plurality of obtained differences is the largest. After a difference that is 0 in the differences is encoded in the foregoing encoding manner, an exponential value corresponding to the difference 0 can be compressed to a smaller quantity of bits. In model training, distribution of the exponential values of the floating point numbers is usually close to normal distribution, and a proportion of differences whose absolute values are less than the threshold in the foregoing plurality of differences is relatively large. Therefore, the differences whose absolute values are less than or equal to the threshold in the differences are also encoded in the foregoing encoding manner. Because a code occupies fewer bits than each exponential value, and a proportion of differences whose absolute values are less than the first threshold in the differences is relatively large, most exponential values can be compressed in the foregoing manner, so that the floating point numbers are compressed, an amount of data to be exchanged between different computing devices is reduced, and data transmission efficiency is improved.

In a possible implementation, the determining one first reference value based on a plurality of pieces of to-be-compressed first data includes: sampling the plurality of pieces of first data, to obtain a plurality of sampled values; dividing the plurality of sampled values into $t1$ groups, and determining a median of a plurality of sampled values in each of the $t1$ groups, to obtain $t1$ medians; and dividing the $t1$ medians into $t2$ groups, determining a median in each of the $t2$ groups to obtain $t2$ medians, and using a median corresponding to the $t2$ medians as the first reference value corresponding to the plurality of pieces of first data.

When there is a relatively large amount of first data, sampling the first data can reduce an amount of data to be processed during reference value determining, and improve reference value determining efficiency.

In a possible implementation, the plurality of floating point numbers further include mantissa values; and the data processing method further includes: The computing device separately compresses the mantissa values of the plurality of floating point numbers, to obtain compressed data of each mantissa value; and obtains compressed data of the plurality of floating point numbers based on compressed data of the exponential values of the plurality of floating point numbers and compressed data of the mantissa values of the plurality of floating point numbers.

The exponential values of the floating point numbers are also compressed, so that an amount of data to be transmitted during data transmission can be further reduced, and data transmission efficiency can be improved.

In a possible implementation, the data processing method further includes: generating first metadata, where the first metadata includes the first reference value, and the first reference value is used to decode compressed data of the plurality of pieces of first data, to obtain the plurality of pieces of first data.

The metadata including the reference value is generated, and the compressed data and the metadata are sent to a receiving end, so that a computing device that receives the compressed data can decode the received compressed data based on the metadata, to obtain uncompressed data.

In a possible implementation, the first metadata further includes a compression type and a mantissa compression level when the plurality of pieces of first data are the exponential values of the plurality of floating point numbers, the compression type indicates whether the mantissa values of the plurality of floating point numbers are compressed, and the mantissa compression level indicates a length of compressed data of the mantissa value in a case that the mantissa value is compressed.

When the floating point data is compressed, whether to compress the mantissa value of the floating point number may be selected, and a compression degree for the mantissa value may be selected. Therefore, when the floating point number is compressed, the metadata further includes the compression type and the mantissa compression level, so that a computing device that receives the compressed data can separately decode an exponent part and a mantissa part of the received compressed data based on the metadata, to obtain the uncompressed floating point data.

In a possible implementation, the method further includes: receiving to-be-decompressed data, where the to-be-decompressed data includes a code part and second metadata, the second metadata includes a second reference value, and the code part includes a plurality of codes; and separately decoding the plurality of codes based on the second reference value and the plurality of codes to obtain a plurality of pieces of second data.

After the computing device receives data, when a reference value exists in the received data, the computing device can determine that the received data is to-be-decompressed data, and can determine a difference corresponding to each code by using codes in the to-be-decompressed data and the code table stored in the computing device, to restore original data based on the difference and the reference value.

In a possible implementation, when the to-be-decompressed data is data corresponding to compressed floating point numbers, the to-be-decompressed data further includes a mantissa part, and the second metadata further includes a data type, a compression type, and a mantissa compression level of the compressed floating point numbers, the compression type indicates whether mantissa values of the floating point numbers are compressed, and the mantissa compression level indicates a length of compressed data of the mantissa value in a case that the mantissa value is compressed. The decoding the to-be-decompressed data based on the second reference value and the plurality of codes to obtain a plurality of pieces of second data includes: determining a length of an exponential value of an uncompressed floating point number and a length of a mantissa value of the uncompressed floating point number based on the data type; separately decoding the plurality of codes based on the length of the exponential value, the second reference value, and the plurality of codes to obtain a plurality of exponential values; when determining, based on the compression type, that the mantissa part in the to-be-decompressed data is compressed data of mantissa values, decoding the compressed data in the mantissa part based on the mantissa compression level and the length of the mantissa value to obtain the plurality of mantissa values; and restoring uncompressed floating point numbers based on the plurality of exponential values and the plurality of mantissa values that are obtained through decoding.

According to a second aspect, this application provides a data processing apparatus. The apparatus includes a communication unit and a processing unit. The communication unit is configured to obtain a plurality of pieces of first data. The processing unit is configured to: determine one first reference value based on the plurality of pieces of to-be-compressed first data; calculate a difference between each piece of first data and the first reference value; determine a code corresponding to each difference; and obtain compressed data of corresponding first data based on each code. Lengths of some or all codes in codes corresponding to all first data are less than lengths of exponential values.

In a possible implementation, the plurality of pieces of first data are exponential values of a plurality of floating point numbers.

In a possible implementation, the processing unit is specifically configured to determine the code corresponding to each difference based on each difference and a code table, where codes corresponding to a plurality of preset differences are recorded in the code table.

In a possible implementation, in the code table, a code corresponding to a difference whose absolute value is greater than a threshold is a fixed value, and the processing unit is specifically configured to: when an absolute value of a first difference is greater than the threshold, use the fixed value and first data corresponding to the first difference as compressed data of the first data corresponding to the first difference.

In a possible implementation, when determining one first reference value based on the plurality of pieces of to-be-compressed first data, the processing unit is specifically configured to: sample the plurality of pieces of first data, to obtain a plurality of sampled values; divide the plurality of sampled values into t1 groups, and determine a median of a plurality of sampled values in each of the t1 groups, to obtain t1 medians; and divide the t1 medians into t2 groups, determine a median in each of the t2 groups to obtain t2 medians, and use a median corresponding to the t2 medians as the first reference value corresponding to the plurality of pieces of first data.

In a possible implementation, the plurality of floating point numbers further include mantissa values; and the processing unit is further configured to: separately compress the mantissa values of the plurality of floating point numbers, to obtain compressed data of each mantissa value; and obtain compressed data of the plurality of floating point numbers based on compressed data of the exponential values of the plurality of floating point numbers and compressed data of the mantissa values of the plurality of floating point numbers.

In a possible implementation, the processing unit is further configured to generate first metadata, where the first metadata includes the first reference value, and the first reference value is used to decode compressed data of the plurality of pieces of first data, to obtain the plurality of pieces of first data.

In a possible implementation, the first metadata further includes a compression type and a mantissa compression level when the plurality of pieces of first data are the exponential values of the plurality of floating point numbers, the compression type indicates whether the mantissa values of the plurality of floating point numbers are compressed, and the mantissa compression level indicates a length of compressed data of the mantissa value in a case that the mantissa value is compressed.

In a possible implementation, the communication unit is further configured to: receive to-be-decompressed data, where the to-be-decompressed data includes a code part and second metadata, the second metadata includes a second reference value, and the code part includes a plurality of codes; and separately decode the plurality of codes based on the second reference value and the plurality of codes to obtain a plurality of pieces of second data.

In a possible implementation, when the to-be-decompressed data is data corresponding to compressed floating point numbers, the to-be-decompressed data further includes a mantissa part, and the second metadata further includes a data type, a compression type, and a mantissa compression level of the compressed floating point numbers, the compression type indicates whether mantissa values of the floating point numbers are compressed, and the mantissa compression level indicates a length of compressed data of the mantissa value in a case that the mantissa value is compressed. The processing unit is specifically configured to: determine a length of an exponential value of an uncompressed floating point number and a length of a mantissa value of the uncompressed floating point number based on the data type; separately decode the plurality of codes based on the length of the exponential value, the second reference value, and the plurality of codes to obtain a plurality of exponential values; when determining, based on the compression type, that the mantissa part in the to-be-decompressed data is compressed data of mantissa values, decode the compressed data in the mantissa part based on the mantissa compression level and the length of the mantissa value to obtain the plurality of mantissa values; and restore uncompressed floating point numbers based on the plurality of exponential values and the plurality of mantissa values that are obtained through decoding.

According to a third aspect, this application provides a computing device. The computing device includes one or more processors, a memory, and a compression engine. The memory stores computer program instructions. The processor executes the computer program instructions to generate to-be-compressed data. The compression engine is configured to implement the data processing method described in any one of the first aspect or the possible implementations of the first aspect, to compress the to-be-compressed data.

In a possible implementation, the computing device further includes a communication engine and a decompression engine. The communication engine is configured to receive to-be-decompressed data, and the decompression engine is configured to implement the data processing method described in any one of the first aspect or the possible implementations of the first aspect, to decode the received to-be-decompressed data.

In a possible implementation, the compression engine and the decompression engine are located in the communication engine.

In a possible implementation, the compression engine is located in each processor, and the decompression engine is located in the communication engine.

In a possible implementation, both the compression engine and the decompression engine are modules independent of the processor, the memory, and the communication engine.

According to a fourth aspect, this application provides a computer-readable storage medium. The computer-readable storage medium stores instructions, and when the instructions are run on a server, the server is enabled to perform the data processing method in any one of the first aspect or the possible implementations of the first aspect.

According to a fifth aspect, this application provides a computer program product. When the computer program product runs on a server, the server is enabled to perform the data processing method in any one of the second aspect or the possible implementations of the second aspect.

## BRIEF DESCRIPTION OF DRAWINGS

To describe technical solutions in embodiments of this application more clearly, the following briefly describes the accompanying drawings for describing the embodiments. It is clear that the accompanying drawings in the following descriptions show some embodiments of this application, and a person of ordinary skill in the art may still derive other drawings from these accompanying drawings without creative efforts.

FIG. 1 is a schematic diagram of an architecture of a distributed training cluster according to an embodiment of this application;
FIG. 2 is a schematic flowchart of a data processing method according to an embodiment of this application;
FIG. 3 is a schematic diagram of a floating point number according to an embodiment of this application;
FIG. 4 is a schematic diagram of a computing device according to an embodiment of this application;
FIG. 5 is a schematic diagram of another computing device according to an embodiment of this application;
FIG. 6 is a schematic diagram of another computing device according to an embodiment of this application;
FIG. 7 is a schematic diagram of a compression engine according to an embodiment of this application;
FIG. 8 is a schematic diagram of another compression engine according to an embodiment of this application;
FIG. 9 is a schematic diagram of another compression engine according to an embodiment of this application;
FIG. 10 is a schematic diagram of determining a reference value according to an embodiment of this application;
FIG. 11 is another schematic diagram of determining a reference value according to an embodiment of this application;
FIG. 12 is a schematic diagram of a payload according to an embodiment of this application;
FIG. 13 is a schematic diagram of another payload according to an embodiment of this application;
FIG. 14 is a schematic diagram of another computing device according to an embodiment of this application;
FIG. 15 is a schematic diagram of another computing device according to an embodiment of this application;
FIG. 16 is a schematic diagram of another computing device according to an embodiment of this application;
FIG. 17 is a schematic diagram of a decompression engine according to an embodiment of this application;
FIG. 18 is a schematic diagram of a decompression engine according to an embodiment of this application; and
FIG. 19 is a schematic diagram of a data processing apparatus according to an embodiment of this application.

## DESCRIPTION OF EMBODIMENTS

With reference to the accompanying drawings, the following describes a technical solution of a data processing method provided in this application.

With development of information technologies, a large amount of data needs to be transmitted or exchanged between different devices over a network. For example, application like high-performance computing (high performance computing, HPC), AI model training, or multimedia data transmission involves transmission of a large amount of data. Improving efficiency of data exchange between different computing devices and reducing a data transmission latency can improve data processing efficiency and improve user experience. For a problem of how to improve efficiency of data exchange between different computing devices, reducing an amount of data to be transmitted between different computing devices is an effective method for improving data transmission efficiency and reducing a data transmission latency.

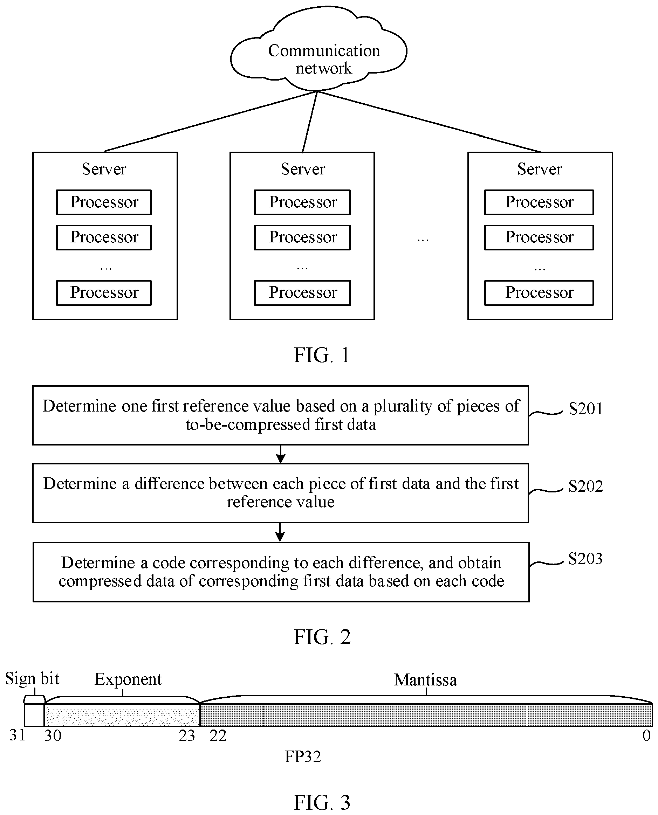

For example, FIG. 1 is a schematic diagram of an architecture of a distributed training cluster according to an embodiment of this application. The distributed training cluster is used to train an AI model in a distributed training scenario. The distributed training cluster includes one or more servers, and each server includes one or more processors. When there are a plurality of servers, the plurality of servers are connected over a network. In a process of training the AI model, a plurality of servers participating in training or different computing devices in a same server can exchange data in a collective communication manner like all-to-all, allgather, or allreduce, to complete training of the AI model. As an AI model scale increases, an amount of data exchanged between different computing devices continuously increases, and a latency in a data exchange process accounts for an increasingly high proportion in model training. It should be noted that the computing device may be a server in a cluster, or may be a processor in a server. This is not specifically limited in embodiments of this application. Therefore, reducing an amount of data to be exchanged in a model training process is an effective way to reduce a data exchange latency and improve model training efficiency.

This application provides a data processing method, to compress data, so as to reduce an amount of data to be transmitted in a data exchange process, improve data transmission efficiency, and reduce a latency. FIG. 2 is a schematic flowchart of a data processing method according to an embodiment of this application. The method includes the following S201 to S203.

S201: Determine one first reference value based on a plurality of pieces of to-be-compressed first data.

The plurality of pieces of to-be-compressed first data are data to be transmitted by a computing device. Before transmitting the plurality of pieces of first data, the computing device needs to compress the plurality of pieces of first data, to reduce a data amount in a transmission process.

Before compressing the plurality of pieces of first data, the computing device first determines one first reference value based on the plurality of pieces of first data. When determining the first reference value, the computing device may collect statistics on one piece of first data with a largest quantity of occurrence times in the plurality of pieces of first data, and use the first data with the largest quantity of occurrence times as the first reference value. Alternatively, the computing device may divide the plurality of pieces of first data into t1 groups, determine a median in each group to obtain t1 medians, then divide the t1 medians into t2 groups, and determine a median in each of the t2 groups to obtain t2 medians. The foregoing process is repeated, until a plurality of finally obtained medians cannot be further grouped, for example, a quantity of values in each group obtained through grouping is less than three, and a median corresponding to the plurality of medians is used as a reference value corresponding to a set. Alternatively, the computing device may first sample the plurality of pieces of first data to obtain a plurality of sampled values, then divide the sampled values into t1 groups, and then determine the first reference value according to the foregoing method.

For example, a first set includes 100 exponential values, and an exponent encoding module 320 samples the 100 exponential values and obtains 27 exponential values. The exponent encoding module 320 first groups every three of the 27 exponential values into one group to obtain nine groups of data, determines a median in each group of data to obtain nine medians, then groups every three of the nine medians into one group to obtain three groups of data, determines a median in each group of data to obtain three medians, and finally uses a median corresponding to the three medians as a reference value corresponding to the first set.

S202: Determine a difference between each piece of first data and the first reference value.

After determining the first reference value, the computing device calculates the difference between each of the plurality of pieces of first data and the first reference value. It should be understood that differences between the plurality of pieces of first data and the first reference value include a positive value, 0, and a negative value.

S203: Determine a code corresponding to each difference, and obtain compressed data of corresponding first data based on each code.

A code table is stored in the computing device, and codes corresponding to a plurality of preset differences are recorded in the code table. After determining the difference between each piece of first data and the first reference value, the computing device searches the code table for the code corresponding to each difference. The code corresponding to each difference is a code corresponding to first data corresponding to the difference, and a code corresponding to each piece of first data is compressed data of each piece of first data.

It should be noted that a correspondence between a difference and a code and a form of compressed data corresponding to each piece of first data in this application are described in detail below, and details are not described herein.

In this embodiment of this application, after compressing the plurality of pieces of first data, the computing device sends compressed data of each piece of first data to another computing device, and the another computing device needs to decode the compressed data. When compressing the plurality of pieces of first data, the computing device generates corresponding first metadata, where the first metadata includes the first reference value. The computing device also sends the metadata to the another computing device, so that the another computing device decodes the compressed data based on the compressed data of each piece of first data and the first metadata, to obtain the plurality of pieces of first data.

In a possible embodiment, the first data may be an exponential value in a floating point number. The floating point number is a number represented by using the scientific notation. The floating point number includes a sign bit, a mantissa, a radix, and an exponent. The floating point number can be represented in the following form:

$$V = (-1)^s * M * R^E$$

S represents the sign bit, and a value of S is 0 or 1. 0 represents a positive floating point number, and 1 represents a negative floating point number. M represents the mantissa. R represents the radix, and a value of R in a binary system is 2. E represents the exponent.

In a computer, when the floating point number is used to represent a number, only the foregoing several variables: the sign bit, the exponent, and the mantissa, need to be determined. Lengths of the exponent and the mantissa vary with precision of the floating point number. For example, in FP64, 64 bits (bit) are used to store one floating point number, and the 64 bits include a 1-bit sign bit, an 11-bit exponent, and a 52-bit mantissa. In FP32, 32 bits are used to store one floating point number, and include a 1-bit sign bit, an 8-bit exponent, and a 23-bit mantissa. In FP16, 16 bits are used to store one floating point number, and include a 1-bit sign bit, a 5-bit exponent, and a 10-bit mantissa. FIG. 3 is a schematic diagram of a floating point number according to an embodiment of this application. FIG. 3 is an example schematic diagram of storage of FP32 data. In 32-bit data, the first bit to the 23rd bit store a mantissa, the 24th bit to the 31st bit store an exponent, and the 32nd bit stores a sign bit.

In application like AI model training, a data type of data such as a weight in a model and an activation value or a gradient generated in a model training process is usually a floating point (float point, FP) type, for example, a double-precision floating point type (FP64), a single-precision floating point type (FP32), and a half-precision floating point type (FP16). Compressing an exponential value in a floating point number can reduce a data amount of the floating point number in a transmission process, improve data transmission efficiency, and reduce a data latency. For AI model training, an amount of data to be exchanged in an AI model training process can be reduced, a data transmission latency can be reduced, and model training efficiency can be improved.

In a possible implementation, if the first data is the exponential value in the floating point number, that is, the computing device compresses the floating point number, and each floating point number further includes a mantissa value, the computing device may further separately compress mantissa values of the plurality of floating point numbers, to obtain compressed data of each mantissa value; and obtain compressed data of the plurality of floating point numbers based on compressed data of exponential values of the plurality of floating point numbers and compressed data of the mantissa values of the plurality of floating point numbers.

It should be understood that, the first metadata further includes a compression type and a mantissa compression level when the plurality of pieces of first data are the exponential values of the plurality of floating point numbers, the compression type indicates whether the mantissa values of the plurality of floating point numbers are compressed, and the mantissa compression level indicates a length of compressed data of the mantissa value in a case that the mantissa value is compressed. When the floating point data is compressed, a user may choose whether to compress the mantissa value of the floating point number, and select a compression degree for the mantissa value. Therefore, when the floating point number is compressed, the first metadata further includes the compression type and the mantissa compression level, so that a computing device that receives the compressed data can separately decode an exponent part and a mantissa part of the received compressed data based on the first metadata, to obtain the uncompressed floating point data.

In a possible implementation, the computing device can further receive compressed data sent by another computing device, that is, receive to-be-decompressed data, where the to-be-decompressed data includes a code part and second metadata, the second metadata includes a second reference value, and the code part includes a plurality of codes. The computing device can separately decode the plurality of codes based on the second reference value and the plurality of codes, to obtain a plurality of pieces of second data. For example, the computing device determines, based on a code and the code table stored in the computing device, a difference corresponding to the code, and then adds the difference to the second reference value to obtain original data corresponding to the code.

In a possible implementation, when the to-be-decompressed data is data corresponding to compressed floating point numbers, the to-be-decompressed data further includes a mantissa part, and the second metadata further includes a data type, a compression type, and a mantissa compression level of the compressed floating point numbers, the compression type indicates whether mantissa values of the floating point numbers are compressed, and the mantissa compression level indicates a length of compressed data of the mantissa value in a case that the mantissa value is compressed. After receiving the to-be-decompressed data obtained by compressing the floating point numbers, the computing device determines a length of an exponential value of an uncompressed floating point number and a length of a mantissa value of the uncompressed floating point number based on the data type; separately decodes the plurality of codes based on the length of the exponential value, the second reference value, and the plurality of codes to obtain a plurality of exponential values; and when determining, based on the compression type, that the mantissa part in the to-be-decompressed data is compressed data of mantissa values, decodes the compressed data in the mantissa part based on the mantissa compression level and the length of the mantissa value to obtain the plurality of mantissa values. For example, if a length of an original mantissa value is 10 bits (bit), and the mantissa compression level indicates that a length of compressed data of the mantissa value is 6 bits, the computing device adds 4 bits to each piece of compressed data in the mantissa part, to obtain the 10-bit mantissa value. Finally, the computing device restores uncompressed floating point numbers based on the plurality of exponential values and the plurality of mantissa values that are obtained through decoding.

The following describes in detail the data processing method provided in this application with reference to a structure of a computing device provided in this application by using an example in which the first data is an exponential value of a floating point number, that is, the floating point number is compressed and decoded.

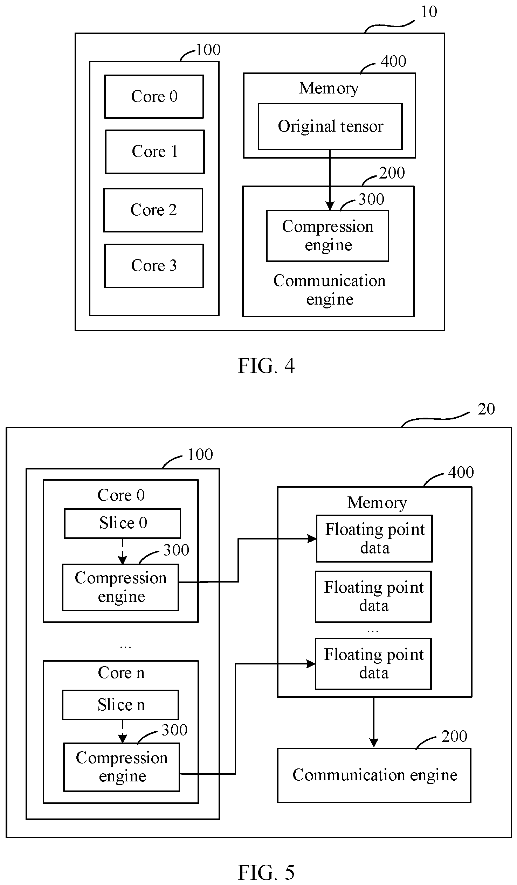

An embodiment of this application provides a computing device. The computing device includes a compression engine. The compression engine can compress a floating point number, to reduce an amount of data to be exchanged between computing devices in a data exchange process, improve data transmission efficiency, and reduce a data transmission latency. FIG. 4 is a schematic diagram of a computing device according to an embodiment of this application. The computing device 10 includes one or more processors 100, a communication engine 200, a compression engine 300, and a memory 400. The compression engine 300 is located in the communication engine 200. The figure shows only one processor, and each processor 100 includes one or more cores (core). The processor 100, the communication engine 200, and the memory 400 are connected by using an on-chip bus (not shown in the figure), and exchange data by using the on-chip bus. A plurality of cores of the computing device 10 separately compute an operator in an AI model through parallel computing, and each generate one slice in an original tensor corresponding to the operator. Each core writes the generated slice into the memory 400, to obtain the complete original tensor corresponding to the operator. When the computing device invokes the communication engine 200 to transmit data between computing devices, after obtaining data in the memory 400, the communication engine 200 invokes the compression engine 300 to compress the data to obtain compressed floating point data. The compression engine 300 sends the compressed floating point data to the communication engine 200, and the communication engine 200 encapsulates the compressed floating point data and sends encapsulated data to another computing device. A structure of the compression engine 300 and a method for compressing a floating point number by the compression engine 300 are described in detail below, and details are not described herein.

FIG. 5 is a schematic diagram of another computing device according to an embodiment of this application. In the computing device 20, the compression engine 300 is deployed in a core. After a core generates a slice of the original tensor, the core invokes the compression engine 300 to compress data, to obtain compressed floating point data. When each core writes compressed floating point data into the memory 400, the compressed floating point data is stored in storage space corresponding to a plurality of inconsecutive addresses, that is, the original tensor is a plurality of inconsecutive data segments in the memory, and the memory 400 records, by using a scatter gather list (scatter gather list, SGL), address information of the floating point data written by each core. The communication engine 200 reads the SGL, reads the floating point data in the memory 400 based on the address information in the SGL, encapsulates the floating point data, and sends encapsulated data to another computing device. A structure of the compression engine 300 and a method for compressing a floating point number by the compression engine 300 are described in detail below, and details are not described herein.

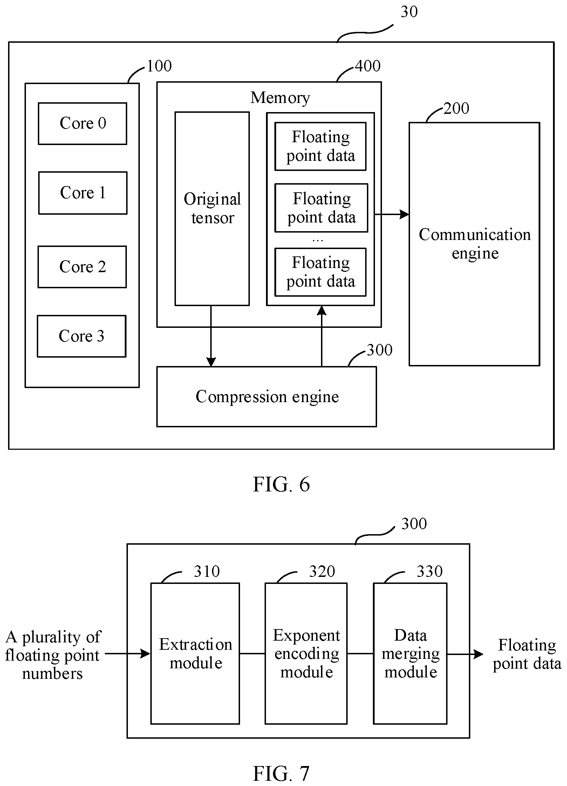

FIG. 6 is a schematic diagram of another computing device according to an embodiment of this application. In the computing device 30, the compression engine 300 is deployed in the computing device 30, and is a module that is in the computing device 30 and that is independent of the processor 100, the communication engine 200, and the memory 400. The one or more processors 100, the communication engine 200, the compression engine 300, and the memory 400 are connected by using an on-chip bus (not shown in the figure), and exchange data by using the on-chip bus. A plurality of cores of the computing device 10 separately compute an operator in an AI model, and each generate one slice in an original tensor corresponding to the operator. Each core writes the generated slice into the memory 400, to obtain the complete original tensor corresponding to the operator. The computing device 30 invokes the compression engine 300 to compress a floating point number in an original tensor to obtain compressed floating point data, and writes the compressed floating point data into the memory 400 again. When the computing device 30 invokes the communication engine 200 to transmit data between computing devices, the communication engine 200 obtains the compressed floating point data from the memory 400, encapsulates the compressed floating point data, and sends encapsulated data to another computing device. A structure of the compression engine 300 and a method for compressing a floating point number by the compression engine 300 are described in detail below, and details are not described herein.

It should be noted that the original tensor refers to data that is generated by the computing device and that needs to be sent to another computing device. The compression engine 300 obtains data of one data packet each time. Due to a limitation of the data packet, the data packet includes some data in the original tensor. For example, the original tensor is floating point numbers of 1 megabyte, and the data packet includes floating point numbers of only 512 bytes. After obtaining the floating point numbers in the foregoing data packet, the compression engine 300 compresses the plurality of floating point numbers included in the data packet to obtain compressed floating point data.

It should be noted that the structure of the computing device is merely an example, and cannot be understood as a specific limitation. The computing device may alternatively be of another structure. This is not specifically limited in embodiments of this application. The communication engine 200 may exchange data with another computing device by using a technology like direct memory access (direct memory access, DMA), remote direct memory access (remote direct memory access, RDMA), RDMA over converged Ethernet (RDMA over converged ethernet, RoCE), and system direct memory access (system DMA, SDMA). The another computing device may be another processor in a same server, or may be a processor in another server. This is not specifically limited in embodiments of this application.

The following describes a structure of the compression engine 300 and a method for compressing floating point data by the compression engine 300.

FIG. 7 is a schematic diagram of a compression engine according to an embodiment of this application. The compression engine 300 can compress a floating point number. When floating point data needs to be exchanged between computing devices, an amount of data to be exchanged between the computing devices can be reduced, and data transmission efficiency can be improved. For example, in a process of training an AI model by using a distributed cluster, an amount of data to be exchanged between computing devices used for training can be reduced, and a model training speed can be improved. The compression engine 300 includes an extraction module 310, an exponent encoding module 320, and a data merging module 330. The extraction module 310 is configured to obtain a plurality of floating point numbers, extract an exponent of each floating point number from the plurality of floating point numbers, and obtain an exponential value corresponding to the exponent of each floating point number. Each floating point number corresponds to one exponent, and each exponent has a corresponding exponential value, that is, each floating point number corresponds to one exponential value. Different floating point numbers may correspond to a same exponential value or different exponential values. For example, the compression engine 300 obtains 100 floating point numbers, and 100 exponential values are correspondingly extracted from the 100 floating point numbers. Some of the 100 exponential values may be the same. For example, three floating point numbers correspond to an exponential value 4, and four floating point numbers correspond to an exponential value 6.

The exponent encoding module 320 is configured to encode the exponential value that is of each floating point number and that is extracted by the extraction module 310, to obtain a code corresponding to each exponential value. In codes corresponding to all exponential values, lengths of codes corresponding to some or all exponential values are less than lengths of the exponential values. This implements compression of the floating point numbers. For example, for 11-bit exponents in floating point numbers of FP64, lengths of codes corresponding to some exponential values are less than 11 bits. The data merging module 330 is configured to merge the codes corresponding to the exponential values and mantissas corresponding to the floating point numbers to obtain compressed floating point data. It should be understood that each floating point number further includes a sign bit, and the data merging module 330 is configured to merge the codes corresponding to the exponential values of the floating point numbers, the mantissas corresponding to the floating point numbers, and sign bits of the floating point numbers.

In this embodiment of this application, after the extraction module 310 extracts the exponential values of the floating point numbers, the exponent encoding module 320 first determines a reference value corresponding to each exponential value, and then encodes each exponential value based on each exponential value and the reference value corresponding to each exponential value, to obtain a code corresponding to each exponential value. It should be noted that a method for determining the reference value based on each exponential value and a method for encoding an exponential value based on the exponential value and the reference value are described below, and details are not described herein.

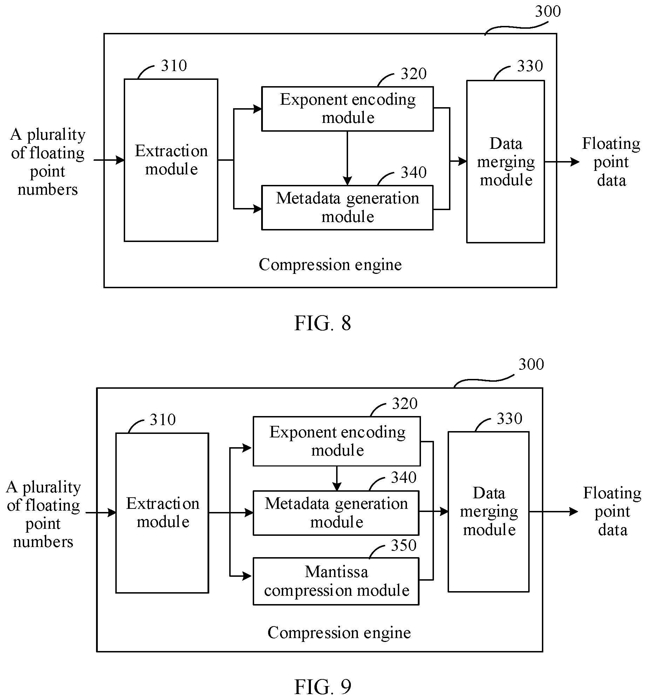

In a possible implementation, FIG. 8 is a schematic diagram of another compression engine according to an embodiment of this application. The compression engine 300 further includes a metadata generation module 340. The metadata generation module 340 is configured to generate metadata, where the metadata includes a data type of the plurality of floating point numbers and a reference value corresponding to the exponential values. The data type includes a type corresponding to a floating point number, for example, FP128, FP64, FP32, or FP16. The reference value in the metadata is used by a computing device that receives compressed floating point data to decode the floating point data, to restore the exponential values based on codes and the reference value that correspond to the exponential values. The data merging module 330 is configured to merge the codes corresponding to the exponential values, the mantissas of the floating point numbers, and the metadata, to obtain the compressed floating point data.

In a possible implementation, FIG. 9 is a schematic diagram of another compression engine according to an embodiment of this application. The compression engine 300 further includes a mantissa compression module 350, and the mantissa compression module 350 is configured to compress mantissa values corresponding to the mantissas of the floating point numbers, to obtain compressed values corresponding to the mantissa values. When the compression engine 300 includes the mantissa compression module 350, the extraction module 310 is further configured to extract the mantissas of the floating point numbers from the plurality of floating point numbers, to obtain the plurality of mantissa values. Each floating point number corresponds to one mantissa, and one mantissa corresponds to one mantissa value, that is, one floating point number corresponds to one mantissa value. When compressing the mantissa, the mantissa compression module 350 may compress the mantissa by truncating the mantissa. For a mantissa of any type of floating point data, the mantissa compression module 350 may truncate a part with a preset length or a preset proportion in a mantissa value as a compressed value corresponding to the mantissa value. For example, the mantissa compression module 350 truncates a first half of characters in a mantissa value as a compressed value corresponding to the mantissa value, or the mantissa compression module 350 truncates first 5 bits in a mantissa value as a compressed value corresponding to each mantissa. For example, for a floating point number of FP32, a mantissa part includes 23 bits, and first 12 bits of each mantissa value may be truncated as a compressed value corresponding to the mantissa value. For a floating point number of FP16, a mantissa part includes 10 bits, and first 5 bits of each mantissa value may be truncated as a compressed value corresponding to the mantissa value.

Optionally, the mantissa compression module 350 may compress the mantissa based on a configured mantissa compression level, where the mantissa compression level indicates the compression engine to compress the mantissa and indicates a length of a compressed value obtained by compressing the mantissa value, and different levels correspond to different lengths of compressed values. For example, there are four mantissa compression levels: four levels 0 to 3. The level 0 indicates that a mantissa is not compressed, the level 1 indicates that first 60% of data in a mantissa value is reserved, the level 2 indicates that first 50% of data in a mantissa value is reserved, and the level 3 indicates that first 40% of data in a mantissa value is reserved. For FP16 floating point data, a mantissa actually includes 10 bits. The level 0 indicates that the mantissa is not compressed. The level 1 indicates that a length of a compressed value obtained by compressing a mantissa value is 6 bits. The level 2 indicates that a length of a compressed value obtained by compressing a mantissa value is 5 bits. The level 3 indicates that a length of a compressed value obtained by compressing a mantissa value is 4 bits. For example, if a mantissa compression level is 3, and a mantissa value corresponding to a floating point number of FP16 is 0011101011, a compressed value corresponding to the mantissa value after compression is 0011.

It should be understood that when the compression engine 300 includes the mantissa compression module 350, the metadata generated by the metadata generation module 340 further includes a compression type and the mantissa compression level. As shown in Table 1, the metadata may include fields shown in Table 1. There are four compression types: not compressing a floating point number, compressing only an exponent, compressing only a mantissa, and compressing both an exponent and a mantissa. The mantissa compression level indicates a length of a compressed value obtained by compressing a mantissa value.

The data merging module 330 is configured to merge the codes corresponding to the exponential values, corresponding compressed values obtained by compressing the mantissa values, and the metadata, to obtain the compressed floating point data. The metadata is used by a computing device that receives the compressed floating point data to restore the floating point numbers based on the fields included in the metadata. A method for restoring the floating point numbers based on the metadata by the computing device is described below, and details are not described herein.

**Table 1**

| Field | Description |
|---|---|
| Data type (data_type) | Indicates a data type of compressed data |
| Compression type (compress_type) | Indicates a data compression type:<br>0: indicates that a floating point number is not compressed<br>1: indicates that only an exponent is compressed<br>2: indicates that only a mantissa is compressed<br>3: indicates that an exponent and a mantissa are compressed |
| Mantissa compression level (mantissa_compress_level) | Indicates a mantissa compression level |

(continued)

| Field | Description |
|---|---|
| Reference value | Indicates a reference value corresponding to each exponent |

It should be understood that the compression type and the mantissa compression level may be configured by a user according to a requirement. The user can configure the compression engine 300 to compress only an exponent of a floating point number, or configure the compression engine 300 to compress both an exponent and a mantissa of a floating point number. When the mantissa is configured to be compressed, the mantissa compression level further needs to be configured, so that the compression engine 300 determines a length of a compressed mantissa. For example, during AI model training, when a relatively short training time is required, the compression type may be set to compressing an exponent and a mantissa, and a relatively high mantissa compression level may be set, so that a length of a compressed value obtained by compressing the mantissa is shorter, an amount of data to be transmitted is reduced to a greatest extent, and a latency caused by communication between computing devices is reduced.

The following describes a method for determining the reference value corresponding to the exponential values by the exponent encoding module 320.

When the exponent encoding module 320 determines the reference value based on the exponential values, the exponent encoding module 320 divides the plurality of exponential values into n sets. Then, one reference value corresponding to a plurality of exponential values in each set is determined based on different exponential values in the sets, to obtain m reference values, where n is a positive integer greater than or equal to 1, and m is a positive integer less than or equal to n.

After the plurality of exponential values are divided into the n sets, when the reference value corresponding to the plurality of exponential values in each set is determined, the reference value corresponding to each set may be determined in the following three manners.

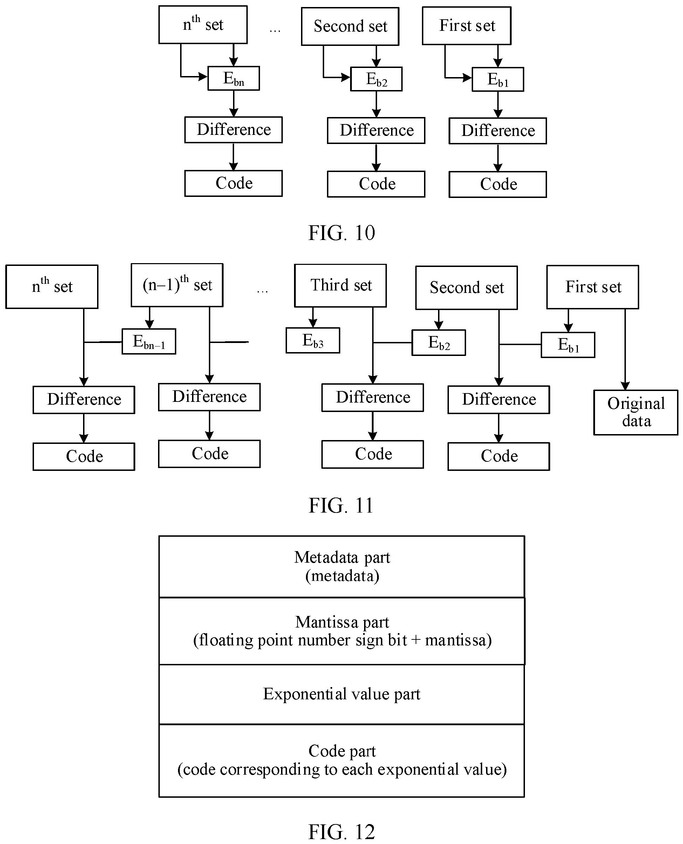

In a first manner, FIG. 10 is a schematic diagram of determining a reference value according to an embodiment of this application. For the plurality of exponential values in each set, the exponent encoding module 320 determines one reference value by using the plurality of exponential values in each set, that is, each set in the n sets corresponds to one reference value $E_{bi}$, where i is a positive integer less than or equal to n. For a first set in the n sets, the exponent encoding module 320 collects statistics on an exponential value with a largest quantity of occurrence times in the first set, and uses the exponential value with the largest quantity of occurrence times as a reference value $E_{b1}$ corresponding to K exponential values in the first set. Alternatively, the exponent encoding module 320 samples the K exponential values in the first set, to obtain a plurality of sampled values; and then determines three sampled values with a largest quantity of occurrence times in the plurality of sampled values, and uses an average value of the three sampled values with the largest quantity of occurrence times as the reference value $E_{b1}$ corresponding to the K exponential values in the first set. It should be noted that the first set is one of the n sets, and for any one of the n sets, a reference value corresponding to a plurality of exponential values in each set is determined according to the foregoing method.

In a second manner, when the reference value corresponding to each set is determined, for a first set in the n sets, K exponential values in the first set are first sampled, to obtain K1 sampled values. For the K1 sampled values, the K1 sampled values are first divided into t1 groups, a median of sampled values in each group is determined to obtain t1 medians, then the t1 medians are divided into t2 groups, and a median in each of the t2 groups is determined to obtain t2 medians. The foregoing process is repeated, until a plurality of finally obtained medians cannot be further grouped, for example, a quantity of values in each group obtained through grouping is less than three, and a median corresponding to the plurality of medians is used as a reference value corresponding to the set.

For example, the first set includes 100 exponential values, and the exponent encoding module 320 samples the 100 exponential values and obtains 27 exponential values. The exponent encoding module 320 first groups every three of the 27 exponential values into one group to obtain nine groups of data, determines a median in each group of data to obtain nine medians, then groups every three of the nine medians into one group to obtain three groups of data, determines a median in each group of data to obtain three medians, and finally uses a median corresponding to the three medians as a reference value corresponding to the first set.

In a third manner, FIG. 11 is another schematic diagram of determining a reference value according to an embodiment of this application. For a plurality of exponential values in each set, the exponent encoding module 320 uses a reference value obtained through calculation based on a plurality of exponential values in a former set as a reference value corresponding to a plurality of exponential values in a latter set. That is, after a reference value $E_{bi}$ is calculated based on a plurality of exponential values in an $i^{th}$ set, the reference value $E_{bi}$ is used as a reference value corresponding to a plurality of exponential values in an $(i+1)^{th}$ set. When the plurality of exponential values in the $(i+1)^{th}$ set are encoded, encoding is performed based on the reference value $E_{bi}$. For the $1^{st}$ set in the n sets, because there is no corresponding reference value, a reference value corresponding to the set may be considered as 0. For the last set in the n sets, no reference value is calculated based on a plurality of exponential values in the set. It should be noted that, when one reference value is determined based on a plurality of exponential values in one set, the method in the first manner or the second manner may be used. For a method for determining one reference value based on a plurality of exponential values in each set, refer to the method for determining a reference value in the first manner.

It should be understood that, when n is equal to 1, that is, when the exponent encoding module 320 does not divide the plurality of exponential values into a plurality of sets, the exponent encoding module 320 can determine, in only the first manner or the second manner, the reference value corresponding to the plurality of exponential values.

It should be noted that, when determining, in any one of the foregoing manners, the reference value corresponding to each set, the exponent encoding module 320 may not sample an exponential value that is 0.

The following describes an operation process of encoding an exponential value by the exponent encoding module 320. After determining the reference value corresponding to the exponential values, the exponent encoding module 320 can encode the exponential values based on the exponential values and the reference value corresponding to the exponential values by using the following three methods.

In a first method, the exponent encoding module 320 encodes an exponential value based on a difference between the exponential value and the reference value corresponding to the exponential value. The exponent encoding module 320 encodes the difference, and then uses a code corresponding to the difference as a code corresponding to the exponential value. Table 2 is a code table according to an embodiment of this application. The code table includes codes corresponding to different differences between exponential values and the reference value. If an absolute value of a difference between an exponential value and a reference value corresponding to the exponential value is less than a first threshold (the first threshold is 4 in Table 2), a code corresponding to the difference is determined based on the code table, and the code of the difference is a code corresponding to the exponential value. If an absolute value of a difference between an exponential value and a reference value corresponding to the exponential value is greater than or equal to a first threshold, a code corresponding to the difference is determined based on the code table, and a code corresponding to the exponential value includes the code corresponding to the difference and an actual value of the exponential value, that is, the code corresponding to the exponential value is a combination of the code corresponding to the difference and the actual value of the exponential value.

It should be noted that the difference may alternatively be encoded in another manner. A correspondence between a difference and a code shown in Table 2 is merely an example, and there may be another correspondence between a difference and a code. In addition, differences whose absolute values are greater than or equal to the first threshold are collectively referred to as "other differences" in Table 2, and all the other differences correspond to a same code. The first threshold is merely used as an example, and cannot be understood as a specific limitation. The first threshold may alternatively be another value, for example, 3, 5, or 6. This is not specifically limited in embodiments of this application.

**Table 2**

| Difference | Code |
|---|---|
| 0 | 00 |
| +1 | 01 |
| -1 | 10 |
| +2 | 110 |
| -2 | 1110 |
| +3 | 11110 |
| -3 | 111110 |
| Other differences | 111111 |

When performing encoding based on an exponential value in each set and a reference value corresponding to the exponential value in each set, the exponent encoding module 320 determines, for a first set in the n sets, a difference between each exponential value in the first set and a reference value $E_{b1}$ corresponding to the first set, and then separately encodes each exponential value in the first set based on the difference between each exponential value and the reference value with reference to Table 2, to obtain a code corresponding to each exponential value in the first set. It should be understood that the first set is any one of the n sets, and for each of the n sets, the exponent encoding module 320 performs the foregoing operation for the first set, to obtain a code corresponding to an exponential value in each set.

For example, it is assumed that a floating point number of FP32 needs to be compressed, an exponential value includes 8 bits, and a reference value is 3. For an exponent whose exponential value is 2, a difference between the exponential value and the reference value is -1, an absolute value of the difference is less than the first threshold 4, and it is determined, based on the code table, that a code corresponding to the difference is 10. Therefore, a code corresponding to the exponential value 2 is 10. For an exponent whose exponential value is 6, a difference between the exponential value and the reference value is 3. Therefore, a code corresponding to the exponential value 6 is 11110. An exponent whose exponential value is 8 is represented as 00001000 in binary mode, a difference between the exponential value and the reference value is 5, an absolute value of the difference is greater than the first threshold 4, and a code corresponding to the difference is 111111. Therefore, a code corresponding to the exponential value 8 is 11111100001000.

According to the foregoing compression method, because the reference value is an exponential value with a larger quantity of occurrence times in a set, when a difference between each of a plurality of exponential values in the set and the reference value is calculated, a quantity of 0s is the largest in a plurality of obtained differences. After a difference that is 0 in the differences is encoded in the foregoing encoding manner, an exponential value corresponding to the difference 0 can be compressed to 2 bits. In addition, because the plurality of exponential values usually meet normal distribution, a proportion of differences whose absolute values are less than the first threshold in the plurality of differences is relatively large. Therefore, the differences whose absolute values are less than the first threshold in the differences are also encoded in the foregoing encoding manner. Because a code occupies fewer bits than each exponential value, and a proportion of differences whose absolute values are less than the first threshold in the differences is relatively large, most exponential values can be compressed in the foregoing manner, so that the floating point numbers are compressed, an amount of data to be exchanged between different computing devices is reduced, and data transmission efficiency is improved.

In a second method, when the exponent encoding module 320 determines a reference value corresponding to each set, if an exponent whose exponential value is 0 is not sampled when an exponential value in each set is sampled, when encoding the exponential value, for a non-0 exponential value, the exponent encoding module 320 encodes an absolute value of a difference between the exponential value and the reference value, and adds one sign bit during encoding to indicate a sign of the difference; and for the exponent whose exponential value is 0, the exponent encoding module 320 directly encodes the exponent to 0. Specifically, Table 3 is a code table according to an embodiment of this application. In Table 3, for two cases: a case in which a difference is 0 and a case in which an exponential value is 0, corresponding codes are both 0, and whether a code 0 indicates a difference 0 or an exponential value 0 is distinguished by using a sign bit. When a sign bit is set to 1 and a code is 0, it indicates that a difference is 0. When a sign bit is set to 0 and a code is 0, it indicates that an exponential value is 0. If an absolute value of a difference between an exponential value and a reference value corresponding to the exponential value is less than a second threshold (the second threshold is 7 in Table 3), a code corresponding to the exponential value is a code of the difference corresponding to the exponential value. If an absolute value of a difference between an exponential value and a reference value corresponding to the exponential value is greater than or equal to a second threshold, a code corresponding to the difference is determined based on the code table, and a code corresponding to the exponential value includes the code corresponding to the difference and an actual value of the exponential value, that is, the code corresponding to the exponential value is a combination of the code corresponding to the difference and the actual value of the exponential value.

For example, if the reference value is 2, when a sign bit is 0, it indicates that the difference between the exponential value and the reference value is positive; or when a sign bit is 1, it indicates that the difference between the exponential value and the reference value is negative. For an exponent whose exponential value is 2, that is, when a difference is 0, a code corresponding to the difference is 0, and a sign bit corresponding to the code is assigned with 1. For an exponent whose exponential value is 0, a code corresponding to the exponential value is 0, and a sign bit corresponding to the code is assigned with 0. For an exponent whose exponential value is 4 or -4, an absolute value of a difference is 2, and a code corresponding to the exponential value 4 or -4 is 110. However, for the exponential value 4, a sign bit corresponding to the code of the exponential value is assigned with 0. For the exponential value - 4, a sign bit corresponding to the code of the exponential value is assigned with 1. For an exponent whose exponential value is 9, an absolute value of a difference is 7, a code of the difference is 11111110, and the exponential value 9 is represented as 00001001 in binary mode. In this case, a code of the exponential value 9 is 1111111000001001, and a sign bit corresponding to the code is assigned with 0.

**Table 3**

| Exponential value | Absolute value of a difference | Code | Sign bit |
|---|---|---|---|
| Non-0 exponential value | 0 | 0 | 1 |
| | 1 | 10 | 0/1 |
| | 2 | 110 | 0/1 |
| | 3 | 1110 | 0/1 |
| | 4 | 11110 | 0/1 |
| | 5 | 111110 | 0/1 |
| | 6 | 1111110 | 0/1 |
| | Other differences | 11111110 | 0/1 |
| 0 | \ | 0 | 0 |

It should be noted that the absolute value of the difference may alternatively be encoded in another manner. A correspondence between an absolute value of a difference and a code shown in Table 3 is merely an example, and there may be another correspondence between a difference and a code. In addition, differences whose absolute values are greater than or equal to the second threshold are collectively referred to as "other differences" in Table 3, and absolute values of all the other differences correspond to a same code. It should be understood that the second threshold is merely used as an example, and cannot be understood as a specific limitation. The second threshold may alternatively be another value, for example, 3, 5, or 6. This is not specifically limited in embodiments of this application.

In a scenario like AI training, data that needs to be transmitted between computing devices is usually sparse, that is, the data to be transmitted usually includes a relatively large quantity of values that are 0. An exponential value that is 0 is compressed into a 1-bit code, so that an amount of data that needs to be transmitted can be greatly reduced. In addition, a sign of a difference between an exponential value and a reference value is indicated by using one sign bit, so that a same code can be used for differences with a same absolute value. Therefore, more differences can be compressed by using the foregoing code, that is, more exponential values are compressed, to better reduce a data amount of compressed floating point data.

In a third method, after the exponent encoding module 320 determines a reference value corresponding to each set, for any set, for example, the foregoing first set, the exponent encoding module 320 separately adds integers whose absolute values are less than a third threshold to a reference value corresponding to the first set, to obtain a plurality of values. For example, if the third threshold is 4, $\pm 1$, $\pm 2$, $\pm 3$, and the like are separately added to the reference value. Then, the plurality of values are encoded to obtain a plurality of codes. When a plurality of exponential values in the first set are encoded, the plurality of exponential values in the first set are separately matched against the plurality of values. If an exponential value is the same as one of the values, a code corresponding to the value is used as a code corresponding to the exponential value. If an exponential value matches none of the plurality of values, a code corresponding to the exponential value includes a code corresponding to another value and the exponential value, where the another value is a value other than the plurality of values. It should be understood that the third threshold is merely used as an example, and cannot be understood as a specific limitation.

Table 4 is a code table between a plurality of values and codes. In Table 4, a reference value is 6. That is, when a reference value corresponding to the plurality of exponential values in the first set is 6, the exponent encoding module can generate the code table shown in Table 4. When an exponential value in the first set is 6, a code corresponding to the exponential value is 00. If an exponential value in the first set is 8, a code corresponding to the exponential value is 110. If an exponential value is 10, the foregoing plurality of floating point numbers are data of the FP32 type, and the exponential value occupies 8 bits, the exponential value 10 is represented as 00001010 in binary mode, and a code corresponding to the exponential value 10 is 11111100001010.

**Table 4**

| Value | Code |
|---|---|
| 6 | 00 |
| 7 | 01 |
| 5 | 10 |
| 8 | 110 |

(continued)

| Value | Code |
|---|---|
| 4 | 1110 |
| 9 | 11110 |
| 3 | 111110 |
| Other values | 111111 |

It should be noted that, when the foregoing plurality of exponents are divided into a plurality of sets, after a reference value is determined for each set, a code table between a value and a code is generated based on the reference value and the third threshold. In addition, when reference values corresponding to two sets are different, mapping relationships between values and codes are also different. For example, if a corresponding reference value in the second set is 4, a corresponding code table may be shown in Table 5. When an exponential value in the second set is 4, a code corresponding to the exponential value is 00. When an exponential value in the second set is 6, a code corresponding to the exponential value is 110. If an exponential value is 8, and the foregoing plurality of floating point numbers are data of the FP32 type, the exponential value 8 is represented as 00001000 in binary mode, and a code corresponding to the exponential value 8 is 11111100001000.

**Table 5**

| Value | Code |
|---|---|
| 4 | 00 |
| 5 | 01 |
| 3 | 10 |
| 6 | 110 |
| 2 | 1110 |
| 7 | 11110 |
| 1 | 111110 |
| Other values | 111111 |

As shown in Table 4 and Table 5, for different sets, when reference values corresponding to two sets are different, different exponential values correspond to different codes, and a same code represents different exponential values. In embodiments of this application, a code corresponding to a reference value is used as a reference code, and a distance between each code and the reference code is defined. For example, the reference code is 00. A distance between a code and the code 00 indicates a difference between a value corresponding to the code and the reference value corresponding to the code 00. For example, it is defined that a distance between a code 01 and the code 00 is 1, a distance between a code 10 and the code 00 is -1, a distance between a code 110 and the code 00 is 2, a distance between a code 1110 and the code 00 is -2, a distance between a code 11110 and the code 00 is 3, and a distance between a code 111110 and the code 00 is -3. According to the foregoing definition, when a corresponding exponential value is restored based on a code, a distance between the code and 00 is first determined, and then the distance is added to the reference value to obtain a corresponding value. The value is the exponential value corresponding to the code.

It should be noted that a quantity of exponential values in each set is not specifically limited in embodiments of this application. Preferably, the quantity of exponential values in each set is a quantity of pieces of data that can be processed by the compression engine in one clock (clock) cycle. For example, if one data packet obtained by the compression engine each time includes FP16 floating point numbers of 512 bytes, that is, includes 256 floating point numbers, and the compression engine can process 128-byte data in one clock cycle, that is, 64 FP16 floating point numbers, the floating point numbers in the data packet can be divided into four sets, and one set includes 64 floating point numbers.

According to the foregoing compression method, because the reference value is an exponential value with a larger quantity of occurrence times in a set, and a plurality of exponential values usually meet normal distribution, after a plurality of values are obtained by separately adding the reference value corresponding to the set to integers whose absolute values are less than the second threshold, the plurality of values are the same as exponential values that account for a relatively large proportion in the set. Then, the plurality of values are encoded. This is equivalent to encoding some exponential values that account for a relatively large proportion in the set. Because a length of a code is less than that of each exponential value, after some exponential values that account for a relatively large proportion in the set are represented by using codes with shorter lengths, compression of most exponential values can be implemented. In this way, most exponential values can be compressed in the foregoing manner, so that the floating point numbers are compressed, an amount of data to be exchanged between different computing devices is reduced, and data transmission efficiency is improved. For example, an amount of data to be exchanged between different computing devices in an AI model training process is reduced, and model training efficiency is improved.

In embodiments of this application, after the compression engine 300 compresses the plurality of floating point numbers, the computing device needs to send, to the communication engine 200, the compressed floating point data that includes the metadata. Alternatively, the computing device writes the floating point data into the memory 400, and the communication engine 200 obtains the floating point data corresponding to the plurality of floating point numbers from the memory 400. Then, the communication engine 200 encapsulates the floating point data into a data packet and sends the data packet to another computing device. When the communication engine 200 sends the data packet, a length of a payload (payload) in one data packet is usually fixed. For example, a payload of an Ethernet data packet is 1500 bytes. In embodiments of this application, an example in which a payload of a data packet is 512 bytes is used. If one data packet obtained by the compression engine 300 includes FP16 floating point numbers of 512 bytes, that is, includes 256 floating point numbers, after compressing the 256 floating point numbers in the data packet, the compression engine 300 obtains a group of corresponding floating point data. After the communication engine 200 obtains the group of compressed floating point data, because the floating point data is less than 512 bytes, for example, a size is 394 bytes after the floating point numbers of 512 bytes are compressed, the communication engine 200 fills the 394 bytes into 512 bytes during encapsulation, and then sends the 512 bytes after encapsulation.

In a possible implementation, when encapsulating the floating point data, the communication engine 200 may further supplement the floating point data in a preset manner. For example, payloads are aligned by 10 bytes or 20 bytes. 20-byte supplementing is used as an example, that is, each payload in the data packet sent by the communication engine 200 is an integer multiple of 20 bytes. If a length of a group of floating point data obtained after the compression engine compresses floating point numbers in a data packet is 235 bytes, after the communication engine 200 obtains the group of floating point data of 235 bytes, the communication engine 200 adds 5 bytes to supplement a payload into 240 bytes, then adds a packet header to the 240-byte data for encapsulation, and sends encapsulated data to another computing device.

In a possible implementation, when the communication engine 200 supplements data in the data packet, as shown in Table 6, the metadata generated by the compression engine 300 further includes a data length, and the data length indicates a length of the floating point data obtained by the communication engine 200, so that the communication engine 200 determines a length of data that needs to be added.

It should be noted that, each time after obtaining floating point numbers in a data packet, the compression engine 300 compresses the plurality of floating point numbers included in the data packet to obtain a group of floating point data. Because a reference value in metadata generated in a compression process is only applicable to restoring the group of floating point data, the communication engine 200 obtains a group of floating point data from the compression engine 300 or the memory 400 each time for supplementing and encapsulation.

**Table 6**

| Field | Description |
|---|---|
| Data length (data_length) | Indicates a length of compressed floating point data |
| Data type (data_type) | Indicates a data type of compressed data |
| Compression type (compress_type) | Indicates a data compression type: 0: indicates that a floating point number is not compressed 1: indicates that only an exponent is compressed 2: indicates that only a mantissa is compressed 3: indicates that an exponent and a mantissa are compressed |
| Mantissa compression level (mantissa_compress_level) | Indicates a mantissa compression level |
| Reference value | Indicates a reference value corresponding to each exponent |

In a possible implementation, if a payload of a data packet sent by the communication engine 200 each time needs to be of a fixed length, for example, the fixed length of the payload is 512 bytes, when compressing floating point numbers in a received data packet, the compression engine 300 may compress exponential values of floating point numbers in a plurality of data packets by using a same reference value to obtain a plurality of groups of floating point numbers, and then the communication engine 200 supplements the plurality of groups of floating point data based on 512 bytes and performs encapsulation.

For example, after obtaining a first data packet, the compression engine 300 determines a reference value corresponding to a plurality of floating point numbers in the data packet, and compresses exponential values to obtain a group of floating point data. If a length of the group of floating point data is less than 512 bytes, after obtaining a plurality of floating point numbers in a second data packet, the compression engine 300 continues to compress the plurality of floating point numbers in the second data packet by using the reference value corresponding to the first data packet. In this way, metadata of the first data packet is the same as that of the second data packet. If a length of data obtained by compressing the first data packet is 215 bytes, a length of data obtained by compressing the second data packet is 230 bytes, and a length of the metadata is 10 bytes, when supplementing the two groups of floating point data based on 512 bytes, the communication engine 200 needs to add 57 bytes and then perform joint encapsulation and sending.

The foregoing describes the computing device and the method for compressing data by using the computing device that are provided in embodiments of this application. After the compression engine 300 obtains the compressed floating point data by compressing the floating point numbers, the communication engine 200 obtains the compressed floating point data, uses the compressed floating point data as a payload (payload), encapsulates the payload into a packet, and sends the packet to another computing device. In the foregoing manner of compressing floating point numbers by the compression engine 300, the compressed floating point data includes a metadata part, a code part, a mantissa part, and an exponential value part. FIG. 12 is a schematic diagram of a payload according to an embodiment of this application. In FIG. 12, a metadata part is used to store the fields shown in Table 1 or Table 6. When the compression engine 300 does not compress a mantissa of a floating point number, a mantissa part is used to store a sign bit and a mantissa value of each floating point number. When the compression engine 300 compresses a mantissa part of a floating point number, a mantissa part is used to store a sign bit of the floating point number and a compressed value of a mantissa value. A code part is used to store a code corresponding to each exponential value. An exponential value part is used to store actual exponential values of some exponents. For example, when an exponential value is encoded by using the foregoing first method, the exponential value part is used to store an exponential value whose absolute value of a difference from the reference value is greater than or equal to the first threshold. When an exponential value is encoded by using the foregoing second method, the exponential value part is used to store an exponential value whose absolute value of a difference from the reference value is greater than or equal to the second threshold. When an exponential value is encoded by using the foregoing third method, the exponential value part is used to store an exponential value greater than or equal to the third threshold.

A sign bit of each floating point number in a plurality of compressed floating point numbers is stored together with a mantissa value of the floating point number or a compressed value corresponding to a mantissa value of the floating point number. That is, when the mantissa part is stored, a sign bit of a first floating point number and a compressed value corresponding to a mantissa value of the first floating point number are first stored, then a sign bit of a second floating point number and a compressed value corresponding to a mantissa value of the second floating point number are stored, and so on, until the compression engine 300 stores, into the mantissa part, sign bits corresponding to the plurality of floating point numbers and compressed values corresponding to mantissa values.

It should be understood that, when the compression engine 300 compresses an exponential value by using the foregoing first method, that is, when a difference is encoded by using the code table shown in Table 2, the code part is used to store a code corresponding to a difference between each exponential value and the reference value. If the compression engine compresses an exponential value by using the foregoing third method, that is, when each exponential value is encoded by using the code table shown in Table 4 or Table 5, the code part is used to store a code corresponding to each value.

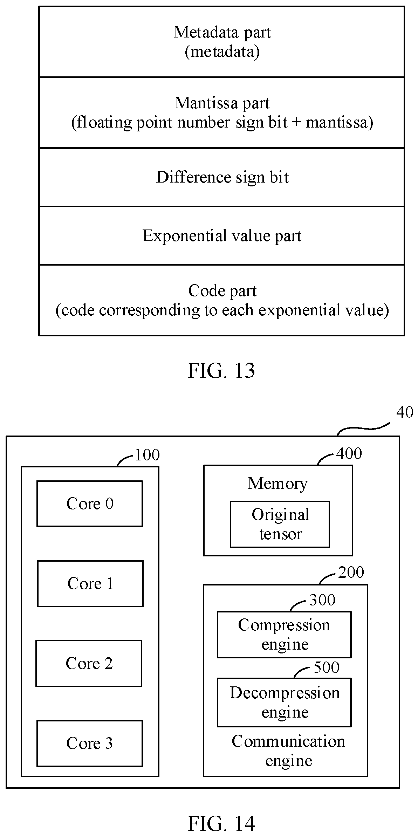

When the compression engine 300 compresses an exponential value by using the foregoing second method, that is, when an absolute value of a difference between the exponential value and the reference value is encoded by using the code table shown in Table 3, a format of a payload part generated by the compression engine 300 is shown in FIG. 13. FIG. 13 is a schematic diagram of another payload according to an embodiment of this application. The payload part in FIG. 13 further includes sign bits corresponding to codes, and the sign bits corresponding to the codes include a sign corresponding to a difference between a non-0 exponential value and a reference value and a sign of an exponent whose exponential value is 0.

It should be noted that, when the compression engine 300 generates the payload in the foregoing format, there is a one-to-one correspondence between data stored in the code part and data stored in the mantissa part. If the compression engine compresses 256 floating point numbers in total, and compresses both exponential values and mantissa values, the mantissa part first stores a sign bit of a first floating point number and a compressed value corresponding to a mantissa value of the first floating point number, and then stores a sign bit of a second floating point number and a compressed value corresponding to a mantissa value of the second floating point number; and the code part first stores a code corresponding to the first floating point number, and then stores a code corresponding to the second floating point number. If the payload further includes sign bits corresponding to codes, a sign bit part corresponding to the codes first stores a sign of a difference between an exponential value of the first floating point number and the reference value, and then stores a sign of a difference between an exponential value of the second floating point number and the reference value.

After the computing device compresses the floating point numbers by using the foregoing compression engine to reduce an amount of to-be-transmitted data, for a computing device that receives the compressed floating point data, the floating point data needs to be decompressed to obtain the complete floating point numbers. The following describes a decompression engine provided in an embodiment of this application.

An embodiment of this application further provides another computing device. The computing device further includes a decompression engine. When receiving compressed floating point data sent by another computing device, the computing device can invoke the decompression engine to decompress the compressed floating point data, to restore a plurality of floating point numbers. A computing device 40 includes one or more processors 100, a communication engine 200, a compression engine 300, a decompression engine 500, and a memory 400. The compression engine 300 may be deployed in the communication engine 200, or may be deployed in a core. The compression engine 300 may alternatively be an independent module other than the processor 100, the communication engine 200, and the memory 400. The decompression engine 500 may be deployed in the communication engine 200, or may be an independent module other than the processor 100, the communication engine 200, and the memory 400. For a structure of the compression engine 300 and a method for compressing a floating point number, refer to operations in related descriptions in FIG. 7 to FIG. 13. A structure of the decompression engine 500 and a method for decompressing compressed floating point data by the decompression engine 500 are described below, and details are not described herein.

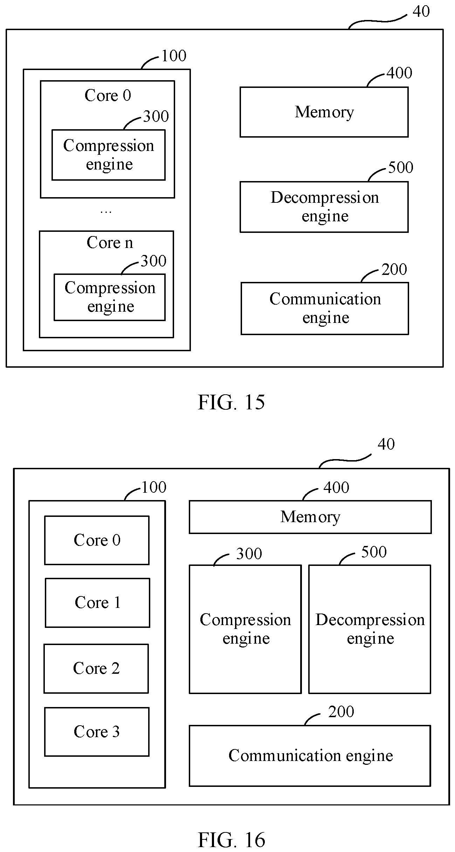

For example, FIG. 14 is a schematic diagram of another computing device according to an embodiment of this application. Both the compression engine 300 and the decompression engine 500 are deployed in the communication engine 200. FIG. 15 is a schematic diagram of another computing device according to an embodiment of this application. The compression engine 300 is deployed in a core, and the decompression engine 500 is an independent module other than the processor 100, the communication engine 200, and the memory 400. FIG. 16 is a schematic diagram of another computing device according to an embodiment of this application. Both the compression engine 300 and the decompression engine 500 are independent modules other than the processor 100, the communication engine 200, and the memory 400. It should be understood that the foregoing is merely an example, and the compression engine 300 and the decompression engine 500 may alternatively be deployed in another form. For example, the compression engine 300 is deployed in a core, and the decompression engine 500 is deployed in the communication engine.

The following describes a structure of the decompression engine 500 and a method for decompressing floating point data by the decompression engine 500.

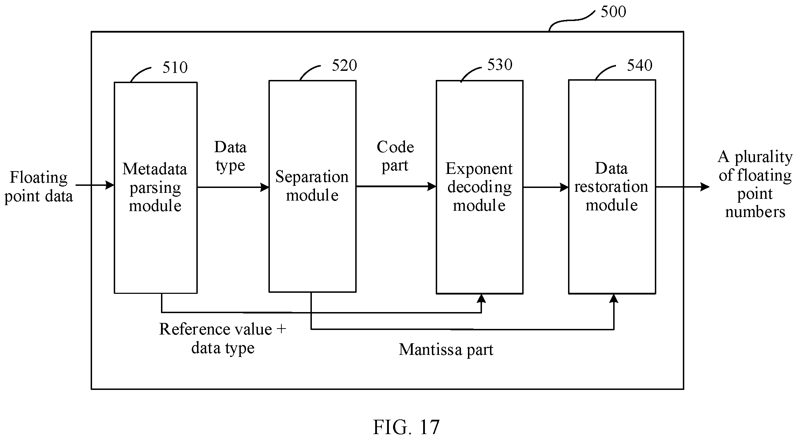

FIG. 17 is a schematic diagram of a decompression engine according to an embodiment of this application. If the compression engine 300 of the foregoing computing device is shown in FIG. 8, and the compression engine 300 can compress only an exponential value, the decompression engine 500 includes a metadata parsing module 510, a separation module 520, an exponent decoding module 530, and a data restoration module 540. The metadata parsing module 510 is configured to obtain the foregoing data type and reference value, and send the data type to the separation module 520, so that the separation module 520 determines a length of each mantissa value based on the data type, and then separates the mantissa part and the code part from the payload. The metadata parsing module 510 is further configured to send the data type and the reference value to the exponent decoding module 530, so that the exponent decoding module 530 determines a length of an exponential value based on the data type, and restores the exponential value based on the reference value and the code part. The separation module 520 is configured to extract the mantissa part, the code part, and an exponential value part from the payload.

For floating point data obtained by encoding an exponential value by using the foregoing first method, after the exponent decoding module 530 obtains the code part and one or more reference values in the metadata, for any code in the code part, for example, a $t^{th}$ code, after obtaining the $t^{th}$ code, the exponent decoding module 530 first determines a reference value corresponding to the code and a difference corresponding to the code, and then adds the difference to the reference value to obtain an actual exponential value corresponding to the code. It should be noted that, if a code obtained by the exponent decoding module 530 is 111111, the exponent decoding module 530 obtains, from the exponential value part, an actual exponential value corresponding to the code.

For example, if the exponent decoding module 530 obtains the code 111111 for the $j^{th}$ time, the exponent decoding module 530 obtains a $j^{th}$ exponential value from the exponential value part, that is, the actual exponential value corresponding to the code. The exponent decoding module 530 obtains p consecutive bits starting from a $[(j-1)p+1]^{th}$ bit, and a value including the p bits is the $j^{th}$ exponential value. Herein, p is a length of the actual exponential value. For example, it is assumed that a compressed floating point number is a floating point number of the FP32 type, that is, an exponential value includes 8 bits, and a reference value corresponding to a set is 4. For a code corresponding to the set, if the code is 00, a reference value corresponding to the code is 4, and a difference corresponding to the code is 0, an exponential value corresponding to the code 00 is 4. If the code is 10, and a difference corresponding to the code is -1, an exponential value corresponding to the code 10 is 3. If the code is 11110, and a difference corresponding to the code is 3, an exponential value corresponding to the code 11110 is 7. If the code is 111111, and the exponent decoding module 530 obtains the code 111111 for the third time, the exponent decoding module 530 obtains 8-bit data starting from a 17th bit of the exponential value part. If the obtained 8-bit data is 00001001, an exponential value corresponding to the code is 9.

For floating point data obtained by encoding an exponential value by using the foregoing second method, after the exponent decoding module 530 obtains the code part and one or more reference values in the metadata, for any code in the code part, for example, a $t^{th}$ code, a reference value corresponding to the code, an absolute value of a difference corresponding to the code, and a sign bit of the difference corresponding to the code are first determined, and then the difference is added to the reference value to obtain an actual exponential value corresponding to the code. It should be noted that, if the code is 11111110, the exponent decoding module 530 obtains, from the exponential value part, the actual exponential value corresponding to the code. For example, it is assumed that a compressed floating point number is a floating point number of the FP32 type, that is, an exponential value includes 8 bits, and a reference value corresponding to a set is 4. For a code corresponding to the set, if the code is 0, and a sign bit corresponding to the code is 1, it indicates that the code is a code corresponding to a difference 0, that is, an exponential value corresponding to the code is 4. If the code is 0, and a sign bit corresponding to the code is 0, it indicates that an exponential value corresponding to the code is 0. If the code is 10, and a sign bit corresponding to the code is 1, it indicates that a difference corresponding to the code is -1, and an exponential value corresponding to the code 10 is 3. If the code is 11110, and a sign bit corresponding to the code is 0, it indicates that a difference corresponding to the code is 4, and an exponential value corresponding to the code 11110 is 8. If the code is 11111110, and the exponent decoding module 530 obtains the code 11111110 for the second time, the exponent decoding module 530 obtains 8-bit data starting from a ninth bit of the exponential value part. If the obtained 8-bit data is 00001000, an exponential value corresponding to the code is 8.

For floating point data obtained by encoding an exponential value by using the third method, the exponent decoding module 530 obtains the code part and one or more reference values in the metadata. For any code in the code part, for example, a $t^{th}$ code, a reference value corresponding to the set is determined. If the code is 00, an exponential value corresponding to the code is the reference value. For another code, based on a distance between the code and the code 00, the distance between the code and the code 00 is added to the reference value, to obtain an exponential value corresponding to the code. It should be noted that, if the code is 111111, the exponent decoding module 530 obtains, from the exponential value part, the actual exponential value corresponding to the code.

For example, a reference value corresponding to a set is 4. For a code corresponding to the set, if the code is 00, an exponential value corresponding to the code is 4; if the code is 10, and a distance between the code and the code 00 is -1, an exponential value corresponding to the code 10 is 3; or if the code is 11110, and a distance between the code and the code 00 is 3, an exponential value corresponding to the code 11110 is 7.

The data restoration module 540 is configured to restore each floating point number based on an exponential value corresponding to an exponent of each floating point number and a sign bit and a mantissa value of the floating point number in the mantissa part. For example, a plurality of compressed floating point numbers are data of the FP32 type. For one of the floating point numbers, it is determined, based on the code part, that a value of an exponent of the floating point number is 8, the exponent is converted into an 8-bit binary number, and a sign bit of the floating point number and a 23-bit mantissa are obtained from the mantissa part, so that an actual value of the floating point number can be obtained.

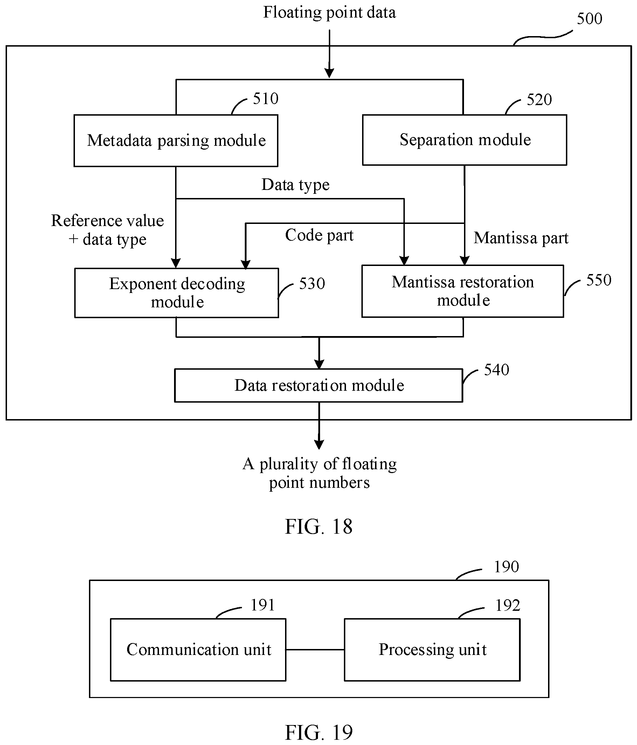

In a possible implementation, FIG. 18 is a schematic diagram of a decompression engine according to an embodiment of this application. If the compression engine 300 includes a mantissa compression module 350, the decompression engine 500 further includes a mantissa restoration module 550. The metadata further includes a compression type and a mantissa compression level. The data type indicates a data type of the foregoing plurality of floating point numbers. The compression type indicates whether the compression engine 300 compresses the floating point number, and whether the compression engine 300 compresses the exponent or the mantissa, or both the exponent and the mantissa. The mantissa compression level indicates a length of a compressed value obtained after the compression engine 300 compresses the mantissa value. If the compression engine 300 compresses the mantissa value, the mantissa part of the payload includes sign bits of the plurality of floating point numbers and compressed values corresponding to the mantissa values of the plurality of floating point numbers.

After determining, based on the compression type, that the mantissa part includes compressed values, the separation module 520 can determine a length of each compressed value based on the mantissa compression level, and then extract each compressed value from the mantissa part. The mantissa restoration module 550 can determine a length of a mantissa value of each floating point number based on the data type, determine, based on the length of the mantissa value and the length of the compressed value, a length deleted when the compression engine 300 compresses the mantissa value, and finally compensate a random number of a corresponding length for each compressed value, to obtain a mantissa value corresponding to each mantissa.

For example, if the separation module 520 determines, based on the compression type, that the compression engine 300 compresses the exponent and the mantissa, determines, based on the data type in the metadata, that the compressed data is data of the FP16 type, that is, the mantissa value includes 10 bits, and determines, based on the mantissa compression level, that the length of the compressed value obtained by compressing the mantissa value is 4 bits, the compression engine 300 deletes a 6-bit character when compressing the mantissa. After obtaining the code part, the separation module 520 extracts one compressed value every 4 bits, and then the mantissa restoration module 550 randomly generates a 6-bit random number, and splices the 6-bit random number and the 4-bit compressed value to obtain the 10-bit mantissa value.

The data restoration module 540 is configured to perform one-to-one corresponding and splicing on an exponential value corresponding to each floating point number output by the exponent decoding module 530 and a mantissa value corresponding to each floating point number output by the mantissa restoration module 550, to obtain each floating point number.

For brief description, the foregoing method embodiment is described as a series of actions. However, a person skilled in the art should appreciate that this application is not limited to the described order of the actions. In addition, a person skilled in the art should also appreciate that all embodiments described in the specification are preferred embodiments, and the related actions are not necessarily mandatory to the present invention.

Other proper step combinations or proper structures of computing devices that can be figured out by a person skilled in the art based on the foregoing content also fall within the protection scope of this application. In addition, a person skilled in the art should also appreciate that all embodiments described in the specification are preferred embodiments, and the related actions are not necessarily mandatory to the present invention.

The data processing method provided in this application and the computing device configured to implement the data processing method are described above in detail with reference to the accompanying drawings. A related apparatus and device provided in this application are described below with reference to the accompanying drawings.

FIG. 19 is a schematic diagram of a data processing apparatus according to an embodiment of this application. The data processing apparatus 190 includes a communication unit 191 and a processing unit 192. The communication unit 191 is configured to obtain a plurality of pieces of first data. The processing unit 192 is configured to: determine one first reference value based on the plurality of pieces of to-be-compressed first data; calculate a difference between each piece of first data and the first reference value; determine a code corresponding to each difference; and obtain compressed data of corresponding first data based on each code. Lengths of some or all codes in codes corresponding to all first data are less than lengths of exponential values. It should be understood that the plurality of pieces of first data may be exponential values of a plurality of floating point numbers.

When determining the code corresponding to each difference, the processing unit 192 is specifically configured to determine the code corresponding to each difference based on each difference and a code table, where codes corresponding to a plurality of preset differences are recorded in the code table. In the code table, a code corresponding to a difference whose absolute value is greater than a threshold is a fixed value, and the processing unit is specifically configured to: when an absolute value of a first difference is greater than the threshold, use the fixed value and first data corresponding to the first difference as compressed data of the first data corresponding to the first difference.

Optionally, the floating point numbers further include mantissa values; and the processing unit 192 may be further configured to: separately compress the mantissa values of the plurality of floating point numbers, to obtain compressed data of each mantissa value; and obtain compressed data of the plurality of floating point numbers based on compressed data of the exponential values of the plurality of floating point numbers and compressed data of the mantissa values of the plurality of floating point numbers.

In this embodiment of this application, after compressing the plurality of pieces of first data, the computing device sends compressed data of each piece of first data to another computing device, and the another computing device needs to decode the compressed data. When compressing the plurality of pieces of first data, the processing unit 192 generates corresponding first metadata, where the first metadata includes the first reference value. The computing device also sends the metadata to the another computing device, so that the another computing device decodes the compressed data based on the compressed data of each piece of first data and the first metadata, to obtain the plurality of pieces of first data.

Optionally, the first metadata further includes a compression type and a mantissa compression level when the plurality of floating point numbers are compressed, the compression type indicates whether the mantissa values of the plurality of floating point numbers are compressed, and the mantissa compression level indicates a length of compressed data of the mantissa value in a case that the mantissa value is compressed.

In a possible implementation, the communication unit 191 is further configured to: receive to-be-decompressed data sent by another device, where the to-be-decompressed data includes a code part and second metadata, the second metadata includes a second reference value, and the code part includes a plurality of codes; and separately decode the plurality of codes based on the second reference value and the plurality of codes to obtain a plurality of pieces of second data.

In a possible implementation, when the to-be-decompressed data is data corresponding to compressed floating point numbers, the to-be-decompressed data further includes a mantissa part, and the second metadata further includes a data type, a compression type, and a mantissa compression level of the compressed floating point numbers, the compression type indicates whether mantissa values of the floating point numbers are compressed, and the mantissa compression level indicates a length of compressed data of the mantissa value in a case that the mantissa value is compressed. The processing unit 192 determines a length of an exponential value of an uncompressed floating point number and a length of a mantissa value of the uncompressed floating point number based on the data type; separately decodes the plurality of codes based on the length of the exponential value, the second reference value, and the plurality of codes to obtain a plurality of exponential values; when determining, based on the compression type, that the mantissa part in the to-be-decompressed data is compressed data of mantissa values, decodes the compressed data in the mantissa part based on the mantissa compression level and the length of the mantissa value to obtain the plurality of mantissa values; and restores uncompressed floating point numbers based on the plurality of exponential values and the plurality of mantissa values that are obtained through decoding.

It should be noted that the data processing apparatus 190 can implement data compression and decompression. For an operation of implementing data compression by the data processing apparatus 190, refer to an operation completed by the compression engine in the foregoing embodiment. For an operation of implementing data decompression, refer to an operation completed by the compression engine in the foregoing embodiment. Details are not described herein again.

An embodiment of this application further provides a computing device. For a schematic diagram of a structure of the computing device, refer to the schematic diagrams of the computing devices corresponding to FIG. 4 to FIG. 6 or FIG. 14 to FIG. 16.

It should be noted that the computing devices each include a plurality of processors 100, and all the processors 100 can exchange data in a collective communication manner like all-to-all, allgather, or allreduce. The processor 100 may be a central processing unit (central processing unit, CPU), a graphics processing unit (graphics processing unit, GPU), an embedded neural-network processing unit (neural-network processing units, NPU), a tensor processing unit (tensor processing unit, TPU), a data processing unit (data processing units, DPU), an accelerated processing unit (accelerated processing unit, APU), a floating point computing unit (floating processing units, FPU), an application-specific integrated circuit (application-specific integrated circuit, ASIC), or the like. Alternatively, the processor may be a single-core processor or a multi-core processor. The processor may be a combination of a CPU and a hardware chip. The hardware chip may be an ASIC, a PLD, or a combination thereof. The PLD may be a complex programmable logic device (complex programmable logic device, CPLD), an FPGA, generic array logic (generic array logic, GAL), or any combination thereof. The processor may alternatively be implemented independently by using a logic device with built-in processing logic, for example, an FPGA or a digital signal processor (digital signal processor, DSP).

The communication engine 200 may be a wired interface or a wireless interface, and is configured to communicate with another module or device. The wired interface may be an Ethernet interface, a local interconnect network (local interconnect network, LIN), or the like. The wireless interface may be a cellular network interface, a wireless local area network interface, or the like. In embodiments of this application, the communication engine 200 may be specifically configured to perform an operation like obtaining to-be-decompressed data sent by another computing device.

The memory 400 may be a nonvolatile memory, for example, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The memory 400 may alternatively be a volatile memory. The volatile memory may be a random access memory (random access memory, RAM), and is used as an external cache. By way of example and not limitation, many forms of RAMs are available, such as a static random access memory (static RAM, SRAM), a dynamic random access memory (dynamic RAM, DRAM), a synchronous dynamic random access memory (synchronous DRAM, SDRAM), double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The bus may be a peripheral component interconnect (peripheral component interconnect, PCI) bus, an extended industry standard architecture (extended industry standard architecture, EISA) bus, or the like. The bus may be classified into an address bus, a data bus, a control bus, or the like.

Optionally, the computing device may further include an input/output interface. The input/output interface is connected to an input/output device, and is configured to receive information input by a user, for example, a compression type and a mantissa compression level that are input by the user.

Specifically, for specific implementation of various operations performed by the computing device, refer to specific operations of data compression and data decoding performed by the computing device in the foregoing method embodiments. Details are not described herein again.

An embodiment of this application further provides a computer-readable storage medium. The computer-readable storage medium stores instructions. When the instructions are run on a processor, the method steps performed by the foregoing computing device may be implemented. For specific implementation of the method steps performed by the processor of the computer-readable storage medium, refer to specific operations in the foregoing embodiments.

Details are not described herein again.

An embodiment of this application further provides a computer program product. The computer program product includes computer instructions. When the computer instructions are executed by a computing device, the computing device performs the method performed by the computing device in the foregoing embodiments.

In the foregoing embodiments, descriptions of the embodiments have respective focuses. For a part that is not described in detail in an embodiment, refer to related descriptions in other embodiments.

All or some of the foregoing embodiments may be implemented by using software, hardware, firmware, or any combination thereof. When software is used to implement embodiments, the foregoing embodiments may be implemented completely or partially in a form of a computer program product. The computer program product includes one or more computer instructions. When the computer program instructions are loaded or executed on a computer, the procedures or functions according to embodiments of the present invention are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium, or a semiconductor medium. The semiconductor medium may be a solid state drive (solid state drive, SSD).

Steps in the method in embodiments of this application may be sequentially scheduled, combined, or deleted according to an actual requirement. Modules in the apparatus in embodiments of this application may be divided, combined, or deleted according to an actual requirement.

Embodiments of this application are described in detail above. The principle and implementation of this application are described in this specification through specific examples. The description about embodiments is merely provided to help understand the method and core ideas of this application. In addition, a person of ordinary skill in the art can make variations to this application in terms of the specific implementations and application scopes according to the ideas of this application. Therefore, the content of this specification shall not be construed as a limit to this application.

**Claims**

1. A data processing method, wherein the method comprises:

   determining a first reference value based on a plurality of pieces of to-be-compressed first data;
   calculating a difference between each piece of first data and the first reference value;
   determining a code corresponding to each difference; and
   obtaining compressed data of corresponding first data based on each code.

2. The method according to claim 1, wherein the plurality of pieces of first data are exponential values of a plurality of floating point numbers.

3. The method according to claim 1, wherein the determining a code corresponding to each difference comprises:
   determining the code corresponding to each difference based on each difference and a code table, wherein codes corresponding to a plurality of preset differences are recorded in the code table.

4. The method according to claim 3, wherein in the code table, a code corresponding to a difference whose absolute value is greater than a threshold is a fixed value, and the obtaining compressed data of corresponding first data based on each code comprises:
   when an absolute value of a first difference is greater than the threshold, using the fixed value and first data corresponding to the first difference as compressed data of the first data corresponding to the first difference.

5. The method according to any one of claims 1 to 4, wherein the determining one first reference value based on a plurality of pieces of to-be-compressed first data comprises:

   sampling the plurality of pieces of first data, to obtain a plurality of sampled values;
   dividing the plurality of sampled values into t1 groups, and determining a median of a plurality of sampled values in each of the t1 groups, to obtain t1 medians; and

dividing the t1 medians into t2 groups, determining a median in each of the t2 groups to obtain t2 medians, and using a median corresponding to the t2 medians as the first reference value corresponding to the plurality of pieces of first data.

6. The method according to any one of claims 2 to 5, wherein the plurality of floating point numbers further comprise mantissa values; and
the method further comprises:

separately compressing the mantissa values of the plurality of floating point numbers, to obtain compressed data of each mantissa value; and
obtaining compressed data of the plurality of floating point numbers based on compressed data of the exponential values of the plurality of floating point numbers and compressed data of the mantissa values of the plurality of floating point numbers.

7. The method according to any one of claims 2 to 6, wherein the method further comprises:
generating first metadata, wherein the first metadata comprises the first reference value, and the first reference value is used to decode compressed data of the plurality of pieces of first data, to obtain the plurality of pieces of first data.

8. The method according to claim 7, wherein the first metadata further comprises a compression type and a mantissa compression level when the plurality of pieces of first data are the exponential values of the plurality of floating point numbers, the compression type indicates whether the mantissa values of the plurality of floating point numbers are compressed, and the mantissa compression level indicates a length of compressed data of the mantissa value in a case that the mantissa value is compressed.

9. The method according to any one of claims 1 to 8, wherein the method further comprises:

receiving to-be-decompressed data, wherein the to-be-decompressed data comprises a code part and second metadata, the second metadata comprises a second reference value, and the code part comprises a plurality of codes; and
separately decoding the plurality of codes based on the second reference value and the plurality of codes to obtain a plurality of pieces of second data.

10. The method according to claim 9, wherein when the to-be-decompressed data is data corresponding to compressed floating point numbers, the to-be-decompressed data further comprises a mantissa part, and the second metadata further comprises a data type, a compression type, and a mantissa compression level of the compressed floating point numbers, the compression type indicates whether mantissa values of the floating point numbers are compressed, and the mantissa compression level indicates a length of compressed data of the mantissa value in a case that the mantissa value is compressed; and
the decoding the to-be-decompressed data based on the second reference value and the plurality of codes to obtain a plurality of pieces of second data comprises:

determining a length of an exponential value of an uncompressed floating point number and a length of a mantissa value of the uncompressed floating point number based on the data type;
separately decoding the plurality of codes based on the length of the exponential value, the second reference value, and the plurality of codes to obtain a plurality of exponential values;
when determining, based on the compression type, that the mantissa part in the to-be-decompressed data is compressed data of mantissa values, decoding the compressed data in the mantissa part based on the mantissa compression level and the length of the mantissa value to obtain the plurality of mantissa values; and
restoring uncompressed floating point numbers based on the plurality of exponential values and the plurality of mantissa values.

11. A data processing apparatus, wherein the apparatus comprises:

a communication unit, configured to obtain a plurality of pieces of first data; and
a processing unit, configured to: determine one first reference value based on the plurality of pieces of to-be-compressed first data;
calculate a difference between each piece of first data and the first reference value;
determine a code corresponding to each difference; and

obtain compressed data of corresponding first data based on each code.

12. The apparatus according to claim 11, wherein the plurality of pieces of first data are exponential values of a plurality of floating point numbers.

13. The apparatus according to claim 11, wherein the processing unit is specifically configured to:
determine the code corresponding to each difference based on each difference and a code table, wherein codes corresponding to a plurality of preset differences are recorded in the code table.

14. The apparatus according to claim 12 or 13, wherein the plurality of floating point numbers further comprise mantissa values; and
the processing unit is further configured to:

separately compress the mantissa values of the plurality of floating point numbers, to obtain compressed data of each mantissa value; and
obtain compressed data of the plurality of floating point numbers based on compressed data of the exponential values of the plurality of floating point numbers and compressed data of the mantissa values of the plurality of floating point numbers.

15. The apparatus according to any one of claims 11 to 14, wherein

the communication unit is further configured to: receive to-be-decompressed data, wherein the to-be-decompressed data comprises a code part and second metadata, the metadata comprises a second reference value, and the code part comprises a plurality of codes; and
separately decode the plurality of codes based on the second reference value and the plurality of codes to obtain a plurality of pieces of second data.

16. The apparatus according to claim 15, wherein when the to-be-decompressed data is data corresponding to compressed floating point numbers, the to-be-decompressed data further comprises a mantissa part, and the second metadata further comprises a data type, a compression type, and a mantissa compression level of the compressed floating point numbers, the compression type indicates whether mantissa values of the floating point numbers are compressed, and the mantissa compression level indicates a length of compressed data of the mantissa value in a case that the mantissa value is compressed; and
the decoding the to-be-decompressed data based on the second reference value and the plurality of codes to obtain a plurality of pieces of second data comprises:

determining a length of an exponential value of an uncompressed floating point number and a length of a mantissa value of the uncompressed floating point number based on the data type;
separately decoding the plurality of codes based on the length of the exponential value, the second reference value, and the plurality of codes to obtain a plurality of exponential values;
when determining, based on the compression type, that the mantissa part in the to-be-decompressed data is compressed data of mantissa values, decoding the compressed data in the mantissa part based on the mantissa compression level and the length of the mantissa value to obtain the plurality of mantissa values; and
restoring uncompressed floating point numbers based on the plurality of exponential values and the plurality of mantissa values.

17. A computing device, wherein the computing device comprises one or more processors, a memory, and a compression engine, the memory stores computer program instructions, the processor executes the computer program instructions to generate to-be-compressed data, and the compression engine is configured to implement the data processing method according to any one of claims 1 to 10, to compress the to-be-compressed data.

18. The computing device according to claim 17, wherein the computing device further comprises a communication engine and a decompression engine, the communication engine is configured to receive to-be-decompressed data, and the decompression engine is configured to implement the data processing method according to any one of claims 1 to 10, to decode the to-be-decompressed data.

19. The computing device according to claim 18, wherein the compression engine and the decompression engine are located in the communication engine.

20. The computing device according to claim 17, wherein the compression engine is located in the processor, and the decompression engine is located in the communication engine.

21. A computer-readable storage medium, wherein the computer-readable storage medium stores a computer program, and when the computer program is executed, operation steps of the method according to any one of claims 1 to 10 are performed.

FIG. 1

| |
| --- |
| Determine one first reference value based on a plurality of pieces of to-be-compressed first data |

S201

| |
| --- |
| Determine a difference between each piece of first data and the first reference value |

S202

| |
| --- |
| Determine a code corresponding to each difference, and obtain compressed data of corresponding first data based on each code |

S203

FIG. 2

FP32

FIG. 3

FIG. 4

FIG. 5

FIG. 6

FIG. 7

300

310

320

330

340

A plurality
of floating
point
numbers

Extraction
module

Exponent encoding
module

Metadata generation
module

Data
merging
module

Floating
point
data

Compression engine

FIG. 8

300

310

320

330

340

350

A plurality
of floating
point
numbers

Extraction
module

Exponent encoding
module

Metadata generation
module

Mantissa
compression module

Data
merging
module

Floating
point
data

Compression engine

FIG. 9

| n<sup>th</sup> set | ... | Second set | First set |

$E_{bn}$  $E_{b2}$  $E_{b1}$

Difference  Difference  Difference

Code  Code  Code

FIG. 10

| n<sup>th</sup> set | (n–1)<sup>th</sup> set | ... | Third set | Second set | First set |

$E_{bn-1}$  $E_{b3}$  $E_{b2}$  $E_{b1}$

Difference  Difference  Difference  Difference  Original data

Code  Code  Code  Code

FIG. 11

| Metadata part (metadata) |
|---|
| Mantissa part (floating point number sign bit + mantissa) |
| Exponential value part |
| Code part (code corresponding to each exponential value) |

FIG. 12

| |
|---|
| Metadata part<br>(metadata) |
| Mantissa part<br>(floating point number sign bit + mantissa) |
| Difference sign bit |
| Exponential value part |
| Code part<br>(code corresponding to each exponential value) |

FIG. 13

FIG. 14

40

100

### Core 0

300

Compression engine

...

### Core n

300

Compression engine

400

Memory

500

Decompression engine

200

Communication engine

FIG. 15

40

100

Core 0

Core 1

Core 2

Core 3

400

Memory

300

Compression engine

500

Decompression engine

200

Communication engine

FIG. 16

FIG. 17

Floating point data

500

Metadata parsing module — 510

Separation module — 520

Data type

Reference value + data type

Code part

Mantissa part

Exponent decoding module — 530

Mantissa restoration module — 550

Data restoration module — 540

A plurality of floating point numbers

FIG. 18

190

Communication unit — 191

Processing unit — 192

FIG. 19

## INTERNATIONAL SEARCH REPORT

| | International application No. |
|---|---|
| | **PCT/CN2023/099570** |

**A. CLASSIFICATION OF SUBJECT MATTER**

G06N3/08(2023.01)i;  G06F5/01(2006.01)i

According to International Patent Classification (IPC) or to both national classification and IPC

**B. FIELDS SEARCHED**

Minimum documentation searched (classification system followed by classification symbols)

IPC:G06N, G06F

Documentation searched other than minimum documentation to the extent that such documents are included in the fields searched

Electronic data base consulted during the international search (name of data base and, where practicable, search terms used)

VEN, CNABS, CNTXT, WOTXT, USTXT, CNKI, IEEE: 压缩, 编码, 差, 基准, 标准, 参考, 指数, 尾数, 解码, 神经网络, compress+, encod+, differen+, standard, reference value, index, mantissa

**C. DOCUMENTS CONSIDERED TO BE RELEVANT**

| Category* | Citation of document, with indication, where appropriate, of the relevant passages | Relevant to claim No. |
|---|---|---|
| X | CN 109543766 A (ZHONGXIANG BOQIAN INFORMATION TECHNOLOGY CO., LTD.) 29 March 2019 (2019-03-29) description, paragraph [0063] | 1-4, 6-21 |
| X | CN 111708511 A (NVIDIA CORP.) 25 September 2020 (2020-09-25) description, paragraphs [0045]-[0051] | 1-4, 6-21 |
| X | US 2021350240 A1 (ARM LTD.) 11 November 2021 (2021-11-11) description, paragraphs [0008]-[0010] | 1-4, 6-21 |
| A | CN 103458460 A (INTERNATIONAL BUSINESS MACHINES CORP.) 18 December 2013 (2013-12-18) entire document | 1-21 |
| A | JP 2012113657 A (MITSUBISHI ELECTRIC CORP.) 14 June 2012 (2012-06-14) entire document | 1-21 |

☐ Further documents are listed in the continuation of Box C. ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **14 September 2023** | **20 September 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

International application No.

**PCT/CN2023/099570**

| Patent document cited in search report | | | Publication date (day/month/year) | Patent family member(s) | | | Publication date (day/month/year) |
|---|---|---|---|---|---|---|---|
| CN | 109543766 | A | 29 March 2019 | None | | | |
| CN | 111708511 | A | 25 September 2020 | US | 2020302284 | A1 | 24 September 2020 |
| | | | | EP | 3713093 | A1 | 23 September 2020 |
| US | 2021350240 | A1 | 11 November 2021 | US | 11580402 | B2 | 14 February 2023 |
| CN | 103458460 | A | 18 December 2013 | US | 2013321181 | A1 | 05 December 2013 |
| | | | | US | 8902090 | B2 | 02 December 2014 |
| | | | | US | 2013321182 | A1 | 05 December 2013 |
| | | | | US | 9094038 | B2 | 28 July 2015 |
| | | | | JP | 2013251895 | A | 12 December 2013 |
| | | | | JP | 6242074 | B2 | 06 December 2017 |
| JP | 2012113657 | A | 14 June 2012 | JP | 5591080 | B2 | 17 September 2014 |

Form PCT/ISA/210 (patent family annex) (July 2022)

**REFERENCES CITED IN THE DESCRIPTION**

**Patent documents cited in the description**

- CN 202210658140
- CN 202211289095